(19) Europäisches Patentamt
European Patent Office
Office européen des brevets

(11) **EP 1 151 537 B1**

(12) **EUROPÄISCHE PATENTSCHRIFT**

(45) Veröffentlichungstag und Bekanntmachung des Hinweises auf die Patenterteilung:
**08.08.2007   Patentblatt 2007/32**

(51) Int Cl.:
*H03H 7/09* (2006.01)        *H03H 7/06* (2006.01)

(21) Anmeldenummer: **00985203.9**

(22) Anmeldetag: **19.12.2000**

(86) Internationale Anmeldenummer:
**PCT/EP2000/012959**

(87) Internationale Veröffentlichungsnummer:
**WO 2001/047107 (28.06.2001 Gazette 2001/26)**

(54) **VERFAHREN ZUM ENTWURF EINER FILTERANORDNUNG**

METHOD FOR DESIGNING A FILTER SYSTEM

PROCEDE POUR LA CONCEPTION D'UN SYSTEME DE FILTRE

(84) Benannte Vertragsstaaten:
**DE ES FR GB IT**

(30) Priorität: **20.12.1999   DE 19961535**

(43) Veröffentlichungstag der Anmeldung:
**07.11.2001   Patentblatt 2001/45**

(73) Patentinhaber: **Vacuumschmelze GmbH & Co. KG
63450 Hanau (DE)**

(72) Erfinder: **HEUMANN, Dirk
61130 Nidderau (DE)**

(74) Vertreter: **Schmuckermaier, Bernhard
PAe Westphal, Mussgnug & Partner,
Mozartstrasse 8
80336 München (DE)**

(56) Entgegenhaltungen:
**WO-A-00/28660        WO-A-99/45643**

EP 1 151 537 B1

## Beschreibung

Die Erfindung betrifft den Entwurf einer Filteranordnung mit mindestens zwei Längszweigen, die Längsinduktivitäten aufweisen und einer Filteranordnung mit mindestens einer Filterstufe, die mindestens einen zwischen die Längszweige geschalteten Querzweig aufweist, und mindestens einer benachbarten Filterstufe, die sich an den Querzweig unmittelbar anschließt.

Eine derartige Filteranordnung, die als Tiefpaß für eine ADSL-Frequenzweiche geeignet ist, ist aus dem Handbuch Anatol I. Zverev, "Handbook of filter synthesis", 1967, z.B. S. 59 Figur 2.39 bekannt.

Eine Filteranordnung mit vier Anschlüssen weist zwei Längszweige auf, die symmetrisch aufgebaut sind. Die Filteranordnung weist mehrere hintereinander geschaltete Filterstufen auf. Die eingangsseitig erste Filterstufe weist pro Längszweig eine Längsinduktivität auf. Die übrigen Filterstufen weisen jeweils eingangsseitig einen Querzweig, der aus einer Kapazität besteht, die zwischen zwei miteinander verkoppelten Querinduktivitäten geschaltet ist, und ausgangsseitig pro Längszweig eine Längsinduktivität auf. Die Längsinduktivitäten und Querinduktivitäten jeder Filterstufe sind miteinander verkoppelt, das heißt, daß die Induktivitäten aus Wicklungen bestehen, die um denselben Magnetkern gewickelt sind. Besonders kostenintensiv sind die Magnetkerne. Für jede zusätzliche Filterstufe sind zwei zusätzliche Magnetkerne erforderlich. Je mehr Filterstufen die Filteranordnung aufweist, umso teurer ist sie.

In der älteren deutschen Patentanmeldung 198 51 872.2 wird zur Erhöhung der Reflexionsdämpfung jede Längsinduktivität durch zwei in Reihe geschaltete, nicht miteinander verkoppelte Längsinduktivitäten ersetzt, wobei zu einer der Längsinduktivitäten ein elektrischer Widerstand parallel geschaltet ist. Dabei werden die Übertragungseigenschaften, wie zum Beispiel Gruppenlaufzeitverzerrung, nicht wesentlich geändert.

Der Erfindung liegt das Problem zugrunde, ein Verfahren zum Entwurf einer Filteranordnung anzugeben, bei dem die Filteranordnung im Vergleich zum Stand der Technik weniger Magnetkerne aufweist ohne Änderung der Übertragungseigenschaften.

Die Aufgabe wird gelöst durch ein Verfahren gemäß Anspruch 1, 2 oder 3. Ausgestaltungen und Weiterbildungen des Erfindungsgedankens sind Gegenstand von Unteransprüchen.

Das erfindungsgemäße Verfahren zum Entwurf einer Filteranordnung mit mindestens zwei Längszweigen, die Längsinduktivitäten aufweisen, mindestens einer Filterstufe, die mindestens einen zwischen die Längszweige geschalteten Querzweig aufweist, und mindestens einer benachbarten Filterstufe, die sich an den Querzweig unmittelbar anschließt, bestimmt die Anordnung der Induktivitäten mittels einer ersten Art von Transformation durch folgende Verfahrensschritte:

Zunächst weist die Filterstufe mindestens eine freie Längsinduktivität des ersten Längszweigs, eine damit verkoppelte freie Längsinduktivität des zweiten Längszweigs und den Querzweig auf, der aus einer Kapazität besteht, die zwischen zwei miteinander verkoppelten Querinduktivitäten geschaltet ist, und zunächst weist die benachbarte Filterstufe mindestens eine freie Längsinduktivität des ersten Längszweigs und eine damit verkoppelte freie Längsinduktivität des zweiten Längszweigs auf.

Anschließend werden in jeden Längszweig zwischen dem Querzweig und der benachbarten Filterstufe eine vorläufige Längsinduktivität und ein diese kompensierende und dazu in Reihe geschaltete Kompensationsinduktivität eingefügt, wobei die vorläufigen Längsinduktivitäten miteinander verkoppelt werden und die Kompensationsinduktivitäten miteinander verkoppelt sind.

Anschließend werden die Kompensationsinduktivitäten in die freien Längsinduktivitäten der benachbarten Filterstufe integriert.

Anschließend werden die vorläufigen Längsinduktivitäten, die freien Längsinduktivitäten der Filterstufe und die Querinduktivitäten derart durch vier miteinander verkoppelte Endinduktivitäten ersetzt, dass ein Ersatzschaltbild der vier Endinduktivitäten mit dem Schaltbild der vorläufigen Längsinduktivitäten, der freien Längsinduktivitäten der Filterstufe und der Querinduktivitäten übereinstimmt.

Eine zweite Art der Transformation sieht folgende Verfahrensschritte vor:

Zunächst weist die Filterstufe eine Längsinduktivität des ersten Längszweigs, eine damit verkoppelte Längsinduktivität des zweiten Längszweigs und den Querzweig auf, und die benachbarte Filterstufe weist zunächst mindestens eine Längsinduktivität des ersten Längszweigs und eine damit verkoppelte Längsinduktivität des zweiten Längszweigs auf.

Anschließend werden die Längsinduktivitäten der Filterstufe jeweils durch eine erste Längsinduktivität, die zumindest einen Teil der freien Längsinduktivität bildet, und eine dazu in Reihe geschaltete zweite Längsinduktivität, zu der ein Widerstand R parallel geschaltet ist, ersetzt, wobei entsprechende Längsinduktivitäten, die zur selben Filterstufe gehören, miteinander verkoppelt sind.

Anschließend werden die vorläufige Längsinduktivität und die Kompensationsinduktivität eingefügt.

Eine dritte Art der Transformation sieht folgende Verfahrensschritte vor:

Zunächst weist die Filterstufe eine Längsinduktivität des ersten Längszweigs, eine damit verkoppelte Längsinduktivität des zweiten Längszweigs und den Querzweig auf, und die benachbarte Filterstufe weist zunächst mindestens eine Längsinduktivität des ersten Längszweigs und eine damit verkoppelte Längsinduktivität des zweiten Längszweigs auf, anschließend werden die Längsinduktivitäten der Filterstufe und der benachbarten Filterstufe jeweils durch eine erste Längsinduktivität und eine dazu in Reihe geschaltete zweite Längsinduktivität, zu der ein Widerstand parallel geschaltet wird, ersetzt, wobei entsprechende Längsinduktivitäten, die zur selben Filterstufe gehören, miteinander verkoppelt werden.

Anschließend werden die ersten Längsinduktivitäten und die zweiten Längsinduktivitäten derselben Filterstufe pro Längszweig durch eine neue erste Längsinduktivität und eine neue zweite Längsinduktivität derart ersetzt, dass die neue zweite Längsinduktivität mit dem Widerstand in Reihe geschaltet ist, diese Reihenschaltung parallel zur neuen ersten Längsinduktivität geschaltet ist, bei derselben Filterstufe werden die neuen ersten Längsinduktivitäten des ersten Längszweigs und des zweiten Längszweigs miteinander verkoppelt und die neuen zweiten Längsinduktivitäten des ersten Längszweigs und des zweiten Längszweigs miteinander verkoppelt.

Anschließend werden in jedem Längszweig der Filterstufe eine weitere vorläufige Längsinduktivität und eine diese kompensierende weitere Kompensationsinduktivität, die zumindest ein Teil der freien Längsinduktivität bildet, zwischen der Parallelschaltung der neuen ersten Längsinduktivität zur Reihenschaltung und der benachbarten Filterstufe eingefügt.

Anschließend werden die weiteren vorläufigen Längsinduktivitäten, die neuen ersten Längsinduktivitäten, die ein weiteres Schaltbild bilden, derart durch vier miteinander verkoppelte End-Längsinduktivitäten ersetzt, dass ein Ersatzschaltbild der vier End-Längsinduktivitäten mit dem weiteren Schaltbild übereinstimmt.

Anschließend werden die vorläufige Längsinduktivität und die Kompensationsinduktivität eingefügt.

Eine Weiterbildung der Erfindung sieht ein Verfahren vor, bei dem eine erste Kondensatorelektrode des Kondensators mit einer ersten Endinduktivität, die mit der benachbarten Filterstufe verbunden wird, und mit einer zweiten Endinduktivität verbunden wird,

bei dem der Wicklungssinn der ersten Endinduktivität bezüglich dem Kondensator mit dem Wicklungssinn der zweiten Endinduktivität bezüglich dem Kondensator übereinstimmt,

bei der eine zweite Kondensatorelektrode des Kondensators mit einer dritten Endinduktivität, die mit der benachbarten Filterstufe verbunden ist, und mit einer vierten Endinduktivität verbunden ist,

bei dem der Wicklungssinn der ersten Endinduktivität bezüglich dem Kondensator entgegengesetzt zum Wicklungssinn der dritten Endinduktivität bezüglich dem Kondensator ist, bei der der Wicklungssinn der dritten Endinduktivität bezüglich dem Kondensator mit dem Wicklungssinn der vierten Endinduktivität bezüglich dem Kondensator übereinstimmt.

Darüber hinaus kann das erfindungsgemäße Verfahren so weitergebildet werden, dass

eine erste Kondensatorelektrode des Kondensators mit einer ersten Endinduktivität verbunden wird, die mit der benachbarten Filterstufe verbunden wird,

eine zweite Endinduktivität mit der ersten Endinduktivität und mit der benachbarten Filterstufe verbunden wird,

der Wicklungssinn der ersten Endinduktivität bezüglich einem ersten Bezugspunkt auf der elektrischen Verbindung zwischen der ersten Endinduktivität und der zweiten Endinduktivität entgegengesetzt zum Wicklungssinn der zweiten Endinduktivität bezüglich dem ersten Bezugspunkt ist,

eine zweite Kondensatorelektrode des Kondensators mit einer dritten Endinduktivität verbunden wird, die mit der benachbarten Filterstufe verbunden ist,

eine vierte Endinduktivität mit der dritten Endinduktivität und mit der benachbarten Filterstufe verbunden wird,

der Wicklungssinn der dritten Endinduktivität bezüglich einem zweiten Bezugspunkt auf der elektrischen Verbindung zwischen der dritten Endinduktivität und der vierten Endinduktivität entgegengesetzt zum Wicklungssinn der vierten Endinduktivität bezüglich dem zweiten Bezugspunkt ist,

der Wicklungssinn der ersten Endinduktivität bezüglich dem Kondensator entgegengesetzt zum Wicklungssinn der dritten Endinduktivität bezüglich dem Kondensator ist.

Weiterhin kann vorgesehen werden, dass,

eine erste Kondensatorelektrode des Kondensators mit einer zweiten Endinduktivität verbunden ist,

bei der die zweite Endinduktivität mit einer ersten Endinduktivität, die mit der benachbarten Filterstufe verbunden ist, verbunden wird,

der Wicklungssinn der ersten Endinduktivität bezüglich einem siebten Bezugspunkt auf der elektrischen Verbindung zwischen der ersten Endinduktivität und der zweiten Endinduktivität entgegengesetzt zum Wicklungssinn der zweiten Endinduktivität bezüglich dem siebten Bezugspunkt ist,

eine zweite Kondensatorelektrode des Kondensators mit einer vierten Endinduktivität verbunden wird,

die vierte Endinduktivität mit einer dritten Endinduktivität, die mit der benachbarten Filterstufe verbunden ist, verbunden wird,

der Wicklungssinn der dritten Endinduktivität bezüglich einem neunten Bezugspunkt auf der elektrischen Verbindung zwischen der dritten Endinduktivität und der vierten Endinduktivität entgegengesetzt zum Wicklungssinn der vierten Endinduktivität bezüglich dem neunten Bezugspunkt ist, und

der Wicklungssinn der ersten Endinduktivität bezüglich dem Kondensator entgegengesetzt zum Wicklungssinn der dritten Endinduktivität bezüglich dem Kondensator ist.

Eine andere Weiterbildung sieht vor, dass

eine erste End-Längsinduktivität mit dem Widerstand der Filterstufe im ersten Längszweig in Reihe geschaltet ist, und eine zweite End-Längsinduktivität zu dieser Reihenschaltung parallel geschaltet wird,

der Wicklungssinn der ersten End-Längsinduktivität bezüglich einem dritten Bezugspunkt auf der elektrischen Verbindung zwischen der ersten End-Längsinduktivität und der zweiten End-Längsinduktivität entgegengesetzt zum Wicklungssinn der zweiten End-Längsinduktivität bezüglich dem dritten Bezugspunkt ist,

eine dritte End-Längsinduktivität mit dem widerstand R der Filterstufe im zweiten Längszweig in Reihe geschaltet wird, und eine vierte End-Längsinduktivität zu dieser Reihenschaltung parallel geschaltet ist,

der Wicklungssinn der dritten End-Längsinduktivität bezüglich einem vierten Bezugspunkt auf der elektrischen Verbindung zwischen der dritten End-Längsinduktivität und der vierten End-Längsinduktivität bezüglich dem vierten Bezugspunkt ist,

der Wicklungssinn der ersten End-Längsinduktivität bezüglich dem Querzweig entgegengesetzt zum Wicklungssinn der dritten End-Längsinduktivität bezüglich dem Querzweig ist.

Alternativ kann vorgesehen werden, dass

eine erste End-Längsinduktivität mit einer zweiten End-Längsinduktivität, zu der der Widerstand R der Filterstufe im ersten Längszweig parallel geschaltet ist, in Reihe geschaltet wird,

der Wicklungssinn der ersten End-Längsinduktivität bezüglich einem fünften Bezugspunkt auf der elektrischen Verbindung zwischen der ersten End-Längsinduktivität und der zweiten End-Längsinduktivität mit dem Wicklungssinn der zweiten End-Längsinduktivität bezüglich dem fünften Bezugspunkt übereinstimmt,

eine dritte End-Längsinduktivität mit einer vierten End-Längsinduktivität, zu der der Widerstand der Filterstufe im zweiten Längszweig parallel geschaltet wird,

der Wicklungssinn der dritten End-Längsinduktivität bezüglich einem sechsten Bezugspunkt auf der elektrischen Verbindung zwischen der dritten End-Längsinduktivität und der vierten End-Längsinduktivität mit dem Wicklungssinn der vierten End-Längsinduktivität bezüglich dem sechsten Bezugspunkt übereinstimmt,

der Wicklungssinn der ersten End-Längsinduktivität bezüglich dem Querzweig entgegengesetzt zum Wicklungssinn der dritten End-Längsinduktivität bezüglich dem Querzweig ist.

Eine andere Alternative besteht darin, dass,

eine zweite End-Längsinduktivität und ein Widerstand der Filterstufe im ersten Längszweig in Reihe geschaltet werden,

bei der eine elektrische Verbindung parallel zur Reihenschaltung aus der zweiten End-Längsinduktivität und dem Widerstand geschaltet wird,

eine erste End-Längsinduktivität zwischen der benachbarten Filterstufe und der Reihenschaltung aus der zweiten End-Längsinduktivität und dem Widerstand geschaltet wird,

der Wicklungssinn der ersten End-Längsinduktivität bezüglich einem achten Bezugspunkt auf der elektrischen Verbindung zwischen der ersten End-Längsinduktivität und der zweiten End-Längsinduktivität mit dem Wicklungssinn der zweiten End-Längsinduktivität bezüglich dem achten Bezugspunkt übereinstimmt,

eine vierte End-Längsinduktivität und ein Widerstand der Filterstufe im ersten Längszweig in Reihe geschaltet werden,

bei der eine elektrische Verbindung parallel zur Reihenschaltung aus der vierten End-Längsinduktivität und dem Widerstand geschaltet wird,

eine dritte End-Längsinduktivität zwischen der benachbarten Filterstufe und der Reihenschaltung aus der vierten End-Längsinduktivität und dem Widerstand geschaltet wird,

der Wicklungssinn der dritten End-Längsinduktivität bezüglich einem zehnten Bezugspunkt auf der elektrischen Verbindung zwischen der dritten End-Längsinduktivität und der vierten End-Längsinduktivität mit dem Wicklungssinn der vierten End-Längsinduktivität bezüglich dem zehnten Bezugspunkt übereinstimmt, und

der Wicklungssinn der ersten End-Längsinduktivität bezüglich dem Querzweig entgegengesetzt zum Wicklungssinn der dritten End-Längsinduktivität bezüglich dem Querzweig ist.

Schließlich kann eine Ausgestaltung der Erfindung dadurch gegeben sein, dass

mindestens eine weitere der Filterstufe benachbarte Filterstufe vorgesehen ist, und

die Kompensationsinduktivität für die Transformation der weiteren benachbarten Filterstufe in die freien Längsinduktivitäten der Filterstufe integriert wird.

Es ist demnach beispielsweise wie folgt vorzugehen: Zunächst weist die Filterstufe mindestens eine freie Längsinduktivität des ersten Längszweigs, eine damit verkoppelte freie Längsinduktivität des zweiten Längszweiges und den Querzweig auf, der aus einer Kapazität besteht, die zwischen zwei miteinander verkoppelten Querinduktivitäten geschaltet ist. Der Begriff "freie Längsinduktivität" bezeichnet eine Längsinduktivität, zu der kein weiteres Bauelement parallel geschaltet ist. Die benachbarte Filterstufe weist zunächst mindestens eine freie Längsinduktivität des ersten Längszweiges und eine damit verkoppelte freie Längsinduktivität des zweiten Längszweigs auf. Dieser Ausgangspunkt entspricht einer Filteranordnung gemäß dem Stand der Technik. Zur Transformation werden anschließend in jeden Längszweig zwischen dem Querzweig und der benachbarten Filterstufe eine vorläufige Längsinduktivität und eine diese kompensierende und dazu in Reihe geschaltete Kompensationsinduktivität eingefügt, wobei die vorläufigen Induktivitäten miteinander verkoppelt sind und die Kompensationsinduktivitäten ebenfalls miteinander verkoppelt sind. Die Schaltungseigenschaften der hierdurch transformierten Filteranordnung bleiben gleich, da die vorläufige Längsinduktivität durch die Kompensationsinduktivität kompensiert wird. Zur weiteren Transformation werden die Kompensationsinduktivitäten anschließend in die freien Längsinduktivitäten der benachbarten Filterstufe integriert. Anschließend werden die vorläufigen Längsinduktivitäten, die freien Längsinduktivitäten der Filterstufe und die Querinduktivitäten derart durch vier miteinander verkoppelte Endinduktivitäten ersetzt, daß ein Ersatzschaltbild der vier Endinduktivitäten mit dem Schaltbild der vorläufigen Längsinduktivitäten, der freien Längsinduktivitäten der Filterstufe und der Querinduktivitäten übereinstimmt.

Da die vier Endinduktivitäten miteinander verkoppelt sind, bestehen die vier Endinduktivitäten aus Wicklungen, die um denselben Magnetkern gewickelt sind.

Mit der beschriebenen Transformation kann pro Filterstufe, die einen Querzweig aufweist, ein Magnetkern eingespart werden, da die freien Induktivitäten und die Querinduktivitäten, für die zwei Magnetkerne erforderlich sind, so transformiert werden, daß nur noch ein Magnetkern erforderlich ist.

Die beschriebene Transformation ist eine Äquivalenztransformation, so daß die Schaltungseigenschaften der Filteranordnung, wie Gruppenlaufzeitverzerrung und Übertragungsfunktion, bei der Transformation erhalten bleiben. Eine erfindungsgemäß entworfene Filteranordnung weist folglich im Vergleich zum Stand der Technik weniger Magnetkerne auf ohne Änderung der Schaltungseigenschaften der Filteranordnung.

Im folgenden soll die Transformation näher erläutert werden. Die Längszweige einer Filteranordnung sind in der Regel paarweise symmetrisch zueinander angeordnet, wobei entsprechende Induktivitäten der Längszweige eines Paares miteinander verkoppelt sind. Aufgrund des symmetrischen Aufbaus genügt es, bei der Erläuterung der Transformation nur einen Längszweig zu betrachten:

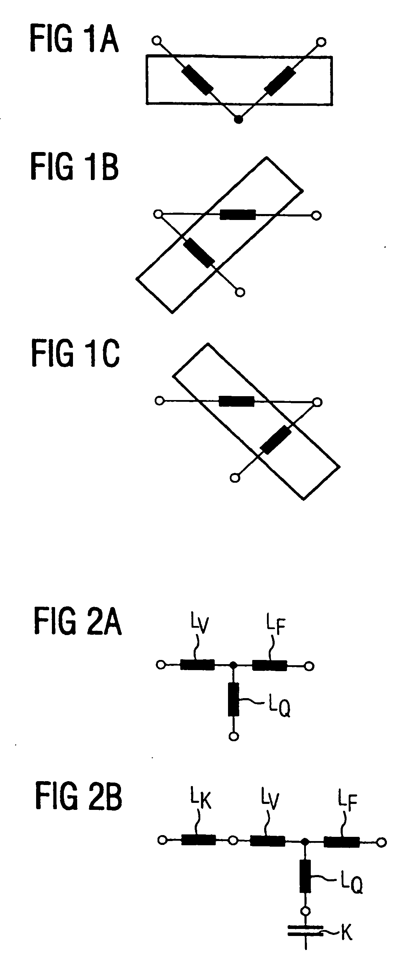

Es existieren drei transformierte Grundschaltungen, die in den Figuren 1a, 1b und 1c dargestellt sind und die dasselbe Ersatzschaltbild, das in Figur 2a dargestellt ist, aufweisen.

Das in Figur 2a gezeigte Ersatzschaltbild entspricht einem Teil einer Filteranordnung gemäß dem Stand der Technik, in die die vorläufige Induktivität $L_V$ eingefügt wurde. Die vorläufige Induktivität $L_V$ ist mit der freien Längsinduktivität $L_F$ und mit der Querinduktivität $L_Q$ verbunden. Aus diesem Ersatzschaltbild erhält man bei geeigneter Transformation die drei transformierten Grundschaltungen. Jede der Grundschaltungen umfaßt zwei miteinander gekoppelte Induktivitäten. Die Verkopplung wird in den Figuren 1a, 1b, 1c durch Einrahmen der miteinander verkoppelten Induktivitäten verdeutlicht. Für die Transformation ist es erforderlich, daß der Wert der vorLäufigen Längsinduktivität $L_V$ folgender Gleichung gehorcht:

$$L_V = - \frac{L_F \cdot L_Q}{L_F + L_Q}$$

In einer Filteranordnung gemäß dem Stand der Technik weist jede Filterstufe pro Längszweig nur die freie Längsinduktivität $L_F$ auf. Deshalb ist es zur Verwirklichung des Ersatzschaltbildes erforderlich, die vorläufige Längsinduktivität $L_V$ einzufügen. Damit die Schaltungseigenschaften erhalten bleiben, muß folglich auch eine diese vorläufige Längsinduktivität $L_V$ kompensierende Kompensationsinduktivität $L_K$ eingefügt werden. Der besseren Übersichtlichkeit halber ist in Figur 2b auch der Kondensator K des Querzweigs dargestellt. Es gilt:

$$L_V = - L_K.$$

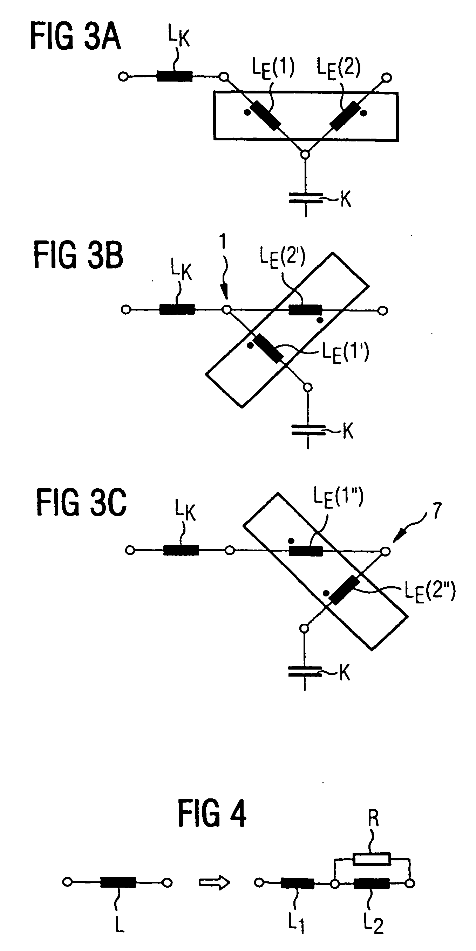

Bei einer Transformation des in Figur 2b dargestellten Ersatzschaltbildes zur Grundschaltung gemäß Figur 1a erhält man das in Figur 3a dargestellte Schaltbild. Diese Transformation wird im folgenden als erste Transformation bezeichnet. Die Kompensationsinduktivität $L_K$ erfordert keinen zusätzlichen Magnetkern, da er aufgrund der Reihenschaltung zur freien Längsinduktivität der benachbarten Filterstufe in die freie Längsinduktivität der benachbarten Filterstufe integriert werden kann, das heißt, zu einer einzigen Induktivität zusammengefaßt werden kann. Da nur die Transformation eines Längszweigs dargestellt wurde, sind in Figur 3a auch nur zwei der vier Endinduktivitäten dargestellt.

Der Kondensator K ist mit einer ersten Endinduktivität $L_E(1)$, die mit der benachbarten Filterstufe verbunden ist, und mit einer zweiten Endinduktivität $L_E(2)$ verbunden. Die Unterscheidung der beiden Endinduktivitäten durch (1) und (2) und nicht durch den Index verdeutlicht, daß es sich bei den beiden Endinduktivitäten $L_E(1)$, $L_E(2)$ zwar um unterschiedliche Induktivitäten handelt, die jedoch miteinander verkoppelt sind. Es gilt:

$$L_E(1) = \frac{L_Q{}^2}{L_F + L_Q}$$

$$L_E(2) = L_F + L_Q$$

Der Wicklungssinn der ersten Endinduktivität $L_E(1)$ bezüglich dem Kondensator K stimmt mit dem Wicklungssinn der zweiten Endinduktivität $L_E(2)$ bezüglich dem Kondensator K überein. Dies ist durch die Punkte an den Endinduktivitäten $L_E(1)$, $L_E(2)$ dargestellt. Die Punkte können statt beide oben auch beide unten sein. Es kommt nicht auf den absoluten Wicklungssinn an, sondern nur auf die Wicklungssinne relativ zueinander.

Die Längszweige eines Paars sind derart symmetrisch zueinander aufgebaut, daß der Wicklungssinn der ersten Endinduktivität $L_E(1)$ bezüglich dem Kondensator K entgegengesetzt zum Wicklungssinn einer dritten Endinduktivität, die der ersten Endinduktivität $L_E(1)$ entspricht, bezüglich dem Kondensator K ist.

Bei einer Transformation ausgehend von dem in Figur 2b dargestellten Ersatzschaltbild zur Grundschaltung, die in Figur 1b dargestellt ist, ergibt sich das in Figur 3b dargestellte Schaltbild. Diese Transformation wird im folgenden als zweite Transformation bezeichnet. Der Kondensator K ist mit der ersten Endinduktivität $L_E(1')$ verbunden, die mit der benachbarten Filterstufe verbunden ist. Die zweite Endinduktivität $L_E(2')$ ist mit der ersten Endinduktivität $L_E(1')$ und mit der benachbarten Filterstufe aber nicht mit dem Kondensator K verbunden. Es gilt:

$$L_E(1') = \frac{L_Q{}^2}{L_F + L_Q}$$

$$L_E(2') = \frac{L_F{}^2}{L_F + L_Q}$$

Der Wicklungssinn der ersten Endinduktivität $L_E(1')$ bezüglich einem ersten Bezugspunkt 1 auf der elektrischen Verbindung zwischen der ersten Endinduktivität $L_E(1')$ und der zweiten Endinduktivität $L_E(2')$ ist entgegengesetzt zum Wicklungssinn der zweiten Endinduktivität $L_E(2')$ bezüglich dem ersten Bezugspunkt 1. Die Wicklungssinne sind wieder anhand der Punkte bei den Endinduktivitäten $L_E(1')$, $L_E(2')$ dargestellt. Auch hier kommt es nur auf die relativen Wicklungssinne an, das heißt, der Punkt bei der ersten Endinduktivität $L_E(1')$ kann statt oben unten sein, wenn bei der zweiten Endinduktivität $L_E(2')$ der Punkt statt rechts links ist.

Die Längszweige eines Paars sind derart symmetrisch zueinander aufgebaut, daß der Wicklungssinn der ersten Endinduktivität $L_E(1')$ bezüglich dem Kondensator K entgegengesetzt zum Wicklungssinn einer dritten Endinduktivität, die der ersten Endinduktivität entspricht, bezüglich dem Kondensator K ist.

Bei einer Transformation ausgehend von dem in Figur 2b dargestellten Ersatzschaltbild zur in Figur 1c dargestellten dritten Grundschaltung ergibt sich das in Figur 3c dargestellte Schaltbild. Diese Transformation wird im folgenden als dritte Transformation bezeichnet. Der Kondensator K ist mit der zweiten Endinduktivität $L_E(2'')$ verbunden. Die zweite Endinduktivität $L_E(2'')$ ist mit der ersten Endinduktivität $L_E(1'')$, die mit der benachbarten Filterstufe verbunden ist, verbunden. Es gilt:

$$L_E(1'') = \frac{L_F{}^2}{L_F + L_Q}$$

$$L_E(2'') = L_F + L_Q$$

Der Wicklungssinn der ersten Endinduktivität $L_E(1'')$ bezüglich einem siebten Bezugspunkt 7 auf der elektrischen Verbindung zwischen der ersten Endinduktivität $L_E(1'')$ und der zweiten Endinduktivität $L_E(2'')$ ist entgegengesetzt zum Wicklungssinn der zweiten Endinduktivität $L_E(2'')$ bezüglich dem siebten Bezugspunkt 7. Die Wicklungssinne sind wieder anhand der Punkte bei den Endinduktivitäten $L_E(1'')$, $L_E(2'')$ dargestellt. Auch hier kommt es nur auf die relativen Wicklungssinne an, das heißt, der Punkt bei der ersten Endinduktivität $L_E(1'')$ kann statt rechts links sein, wenn bei der zweiten Endinduktivität $L_E(2'')$ der Punkt statt unten oben ist.

Zur Erhöhung der Reflexionsdämpfung der Filteranordnung ist es vorteilhaft, eine Längsinduktivität L des ersten Längszweigs und eine damit verkoppelte Längsinduktivität des zweiten Längszweigs derselben Filterstufe jeweils durch eine erste Längsinduktivität $L_1$ und eine dazu in Reihe geschaltete zweite Längsinduktivität $L_2$, zu der ein Widerstand R parallel geschaltet ist, zu ersetzen, wobei sich entsprechende Längsinduktivitäten, die zur selben Filterstufe gehören, miteinander verkoppelt sind (siehe Figur 4). Es sind also die beiden ersten Längsinduktivitäten $L_1$ miteinander verkoppelt und die beiden zweiten Längsinduktivitäten $L_2$ miteinander verkoppelt. Durch diese passive Transformation kann die Filteranordnung an einen komplexen Abschlußwiderstand angepaßt werden, so daß die Reflexionsdämpfung im Vergleich zu einer Filteranordnung ohne passive Transformation stark erhöht ist.

Ohne passive Transformation ist die freie Längsinduktivität $L_F$ beispielsweise gleich der Längsinduktivität L.

Mit passiver Transformation ist die freie Längsinduktivität $L_F$ beispielsweise die erste Längsinduktivität L1.

Die freie Längsinduktivität $L_F$ kann immer durch eine Längsinduktivität L oder eine erste Längsinduktivität $L_1$ und eine Kompensationsinduktivität, die durch Transformation einer weiteren, der Filterstufe benachbarten Filterstufe entsteht, zusammengesetzt sein.

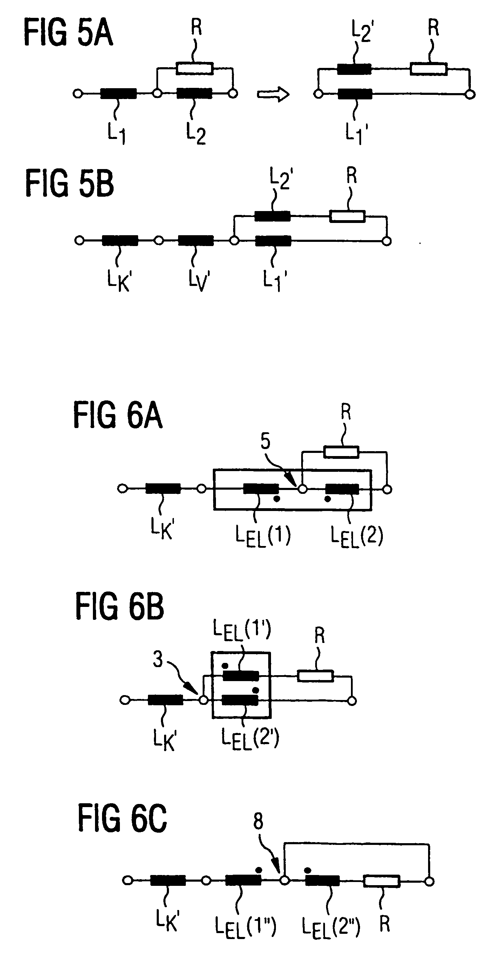

Das in Figur 4 dargestellte Ergebnis der passiven Transformation kann entsprechend zu den Transformationen des Querzweigs weitertransformiert werden. Dazu wird nach der passiven Transformation zunächst eine Parallel-Transformation durchgeführt. Diese Transformation ist in Figur 5a dargestellt. Die ersten Längsinduktivitäten $L_1$ und die zweiten Längsinduktivitäten $L_2$ derselben Filterstufe pro Längszweig werden durch eine neue erste Längsinduktivität $L_1'$ und eine neue zweite Längsinduktivität $L_2'$ derart ersetzt, daß die neue zweite Längsinduktivität $L_2'$ mit dem Widerstand R in Reihe geschaltet ist, und diese Reihenschaltung parallel zur neuen ersten Längsinduktivität $L_1'$ geschaltet ist. Bei derselben Filterstufe sind die neuen ersten Längsinduktivitäten $L_1'$ des ersten Längszweigs und des zweiten Längszweigs miteinander verkoppelt. Ferner sind die neuen zweiten Längsinduktivitäten $L_2'$ des ersten Längszweigs und des zweiten Längszweigs bei derselben Filterstufe miteinander verkoppelt.

Um ein entsprechendes Ersatzschaltbild zum Ersatzschaltbild aus Figur 2b zu erzeugen, werden eine weitere vorläufige Längsinduktivität $L_V'$ und eine diese kompensierende weitere Kompensationsinduktivität $L_K'$ zwischen der oben beschriebenen Parallelschaltung und der benachbarten Filterstufe eingefügt (siehe Figur 5b). Die weitere Kompensationsinduktivität $L_K'$ bildet zumindest einen Teil der freien Längsinduktivität $L_F$ der Filterstufe. Es gilt:

$$L_K' = \frac{L_2' \cdot L_1'}{L_2' + L_1'}$$

Um eine erste Transformation gemäß Figur 1a durchzuführen, werden die weiteren vorläufigen Längsinduktivitäten $L_V'$, die neuen ersten Längsinduktivitäten $L_1'$ und die neuen zweiten Längsinduktivitäten $L_2'$ derart durch vier miteinander verkoppelte Endinduktivitäten $L_{EL}(1)$, $L_{EL}(2)$ ersetzt, daß ein Ersatzschaltbild der End-Längsinduktivitäten $L_{EL}(1)$, $L_{EL}(2)$ mit einem Schaltbild, das durch die vorläufigen Längsinduktivitäten $L_V'$, die neuen ersten Längsinduktivitäten $L_1'$ und die neuen zweiten Längsinduktivitäten $L_2'$ gebildet wird, übereinstimmt (siehe Figur 6a).

Die erste End-Längsinduktivität $L_{EL}(1)$ ist mit der zweiten End-Längsinduktivität $L_{EL}(2)$, zu der der Widerstand R der Filterstufe parallel geschaltet ist, in Reihe geschaltet. Es gilt:

$$L_{EL}(1) = \frac{L_2'}{L_2' + L_1'}$$

$$L_{EL}(2) = L_2' + L_1'$$

Der Wicklungssinn der ersten End-Längsinduktivität $L_{EL}(1)$ bezüglich einem fünften Bezugspunkt 5 auf der elektrischen Verbindung zwischen der ersten End-Längsinduktivität $L_{EL}(1)$ und der zweiten End-Längsinduktivität $L_{EL}(2)$ stimmt mit dem Wicklungssinn der zweiten Endinduktivität $L_{EL}(2)$ bezüglich dem fünften Bezugspunkt 5 überein. Auch hier kommt es nur auf die relativen Wicklungssinne an.

Ausgehend von der parallel transformierten Filteranordnung aus Figur 5b kann zum Beispiel auch die Transformation gemäß Figur 1b, das heißt die zweite Transformation, durchgeführt werden. Es ergibt sich die in Figur 6b dargestellte Filteranordnung. Eine erste End-Längsinduktivität $L_{EL}(1')$ ist mit dem Widerstand R der Filterstufe im ersten Längszweig in Reihe geschaltet. Eine zweite End-Längsinduktivität $L_{EL}(2')$ ist zu dieser Reihenschaltung parallel geschaltet. Es gilt:

$$L_{EL}(1') = \frac{L_2'^2}{L_1' + L_2'}$$

$$L_{EL}(2') = \frac{L_1'^2}{L_1' + L_2'}$$

Der Wicklungssinn der ersten End-Längsinduktivität $L_{EL}(1')$ bezüglich einem dritten Bezugspunkt 3 auf der elektrischen Verbindung zwischen der ersten End-Längsinduktivität $L_{EL}(1')$ und der zweiten End-Längsinduktivität $L_{EL}(2')$ ist entgegengesetzt zum Wicklungssinn der zweiten End-Längsinduktivität $L_{EL}(2')$ bezüglich dem dritten Bezugspunkt 3. Auch hier kommt es nur auf die relativen Wicklungssinne an.

Ausgehend von der parallel transformierten Filteranordnung aus Figur 5b kann zum Beispiel auch die dritte Transformation gemäß Figur 1c durchgeführt werden. Eine zweite End-Längsinduktivität $L_{EL}(2'')$ und ein Widerstand R sind in Reihe geschaltet. Eine elektrische Verbindung ist parallel zur Reihenschaltung aus der zweiten End-Längsinduktivität $L_{EL}(2'')$ und dem Widerstand R geschaltet. Eine erste End-Längsinduktivität $L_{EL}(1'')$ ist mit der Reihenschaltung aus der zweiten End-Längsinduktivität $L_{EL}(2'')$ und dem Widerstand R verbunden.

Es gilt:

$$L_{EL}(1'') = L_2'' + L_1''$$

$$L_{EL}(2'') = L_1''^2 / (L_2'' + L_1'')$$

Der Wicklungssinn der ersten End-Längsinduktivität $L_{EL}(1'')$ bezüglich einem achten Bezugspunkt 8 auf der elektrischen Verbindung zwischen der ersten End-Längsinduktivität $L_{EL}(1')$ und der zweiten End-Längsinduktivität $L_{EL}(2')$ stimmt mit dem Wicklungssinn der zweiten End-Längsinduktivität $L_{EL}(2'')$ bezüglich dem achten Bezugspunkt 8 überein. Auch hier kommt es nur auf die relativen Wicklungssinne an.

Vorzugsweise sind mehr als zwei Filterstufen vorgesehen.

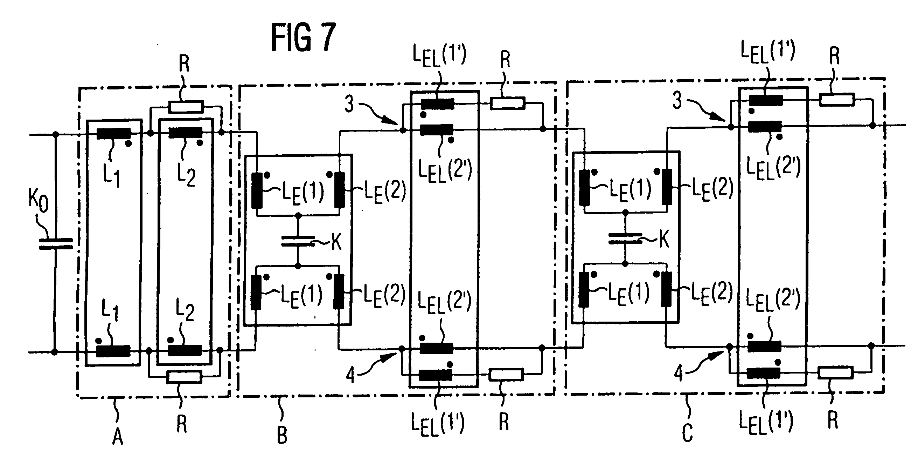

Figur 7 zeigt eine Filteranordnung mit einer ersten Filterstufe A, einer zweiten Filterstufe B und einer dritten Filterstufe C. Die Querzweige der Filteranordnung gehen aus der ersten Transformation hervor. Die Längsinduktivitäten der zweiten Stufe B und der dritten Stufe C gehen aus zweiten Transformationen mit vorheriger passiver Transformation und Parallel-Transformation hervor. Die Längsinduktivitäten der ersten Filterstufe A sind zur Erhöhung der Reflexionsdämpfung einer passiven Transformation unterzogen worden. Die Werte der Induktivitäten, Widerstände und Kondensatoren lassen sich der Tabelle 1 entnehmen. Die Wicklungssinne der ersten End-Längsinduktivität $L_{EL}(1')$ und der zweiten End-Längsinduktivität $L_{EL}(2')$ der zweiten Filterstufe B im oberen Längszweig sind bezüglich dem dritten Bezugspunkt 3 zueinander entgegengesetzt. Der dritte Bezugspunkt 3 liegt auf der elektrischen Verbindung zwischen der ersten End-Längsinduktivität $L_{EL}(1')$ und der zweiten End-Längsinduktivität $L_{EL}(2')$. Das Entsprechende gilt für die End-Längsinduktivitäten $L_{EL}(1')$, $L_{EL}(2')$ der dritten Filterstufe C im oberen Längszweig. Das Entsprechende gilt für die End-Längsinduktivitäten $L_{EL}(1')$, $L_{EL}(2')$ der zweiten Filterstufe B bzw. der dritten Filterstufe C im unteren Längszweig bezüglich eines vierten Bezugspunkts 4.

Tabelle 1

| Bauelement | Stufe | Wert |
|:----------:|:-----:|:----:|
| K0 | 0 | 6.8 nF |
| $L_1$ | A | 763 $\mu$H |
| $L_2$ | A | 2598 $\mu$H |
| $2*R_T$ | A | 27.5 Ohm |
| $L_E(1)$ | B | 5.7 $\mu$H |
| $L_E(2)$ | B | 907 uH |
| K | B | 11.7 nF |
| $L_{EL}(1')$ | B | 235 $\mu$H |
| $L_{EL}(2')$ | B | 2974 $\mu$H |
| $2*R$ | B | 51.7 Ohm |
| $L_E(1)$ | C | 3.6 $\mu$H |
| $L_E(2)$ | C | 462 $\mu$H |
| K | C | 10.5 nF |
| $L_{EL}(1')$ | C | 113 $\mu$H |
| $L_{EL}(2')$ | C | 1569 $\mu$H |
| $2*R$ | C | 26.7 Ohm |

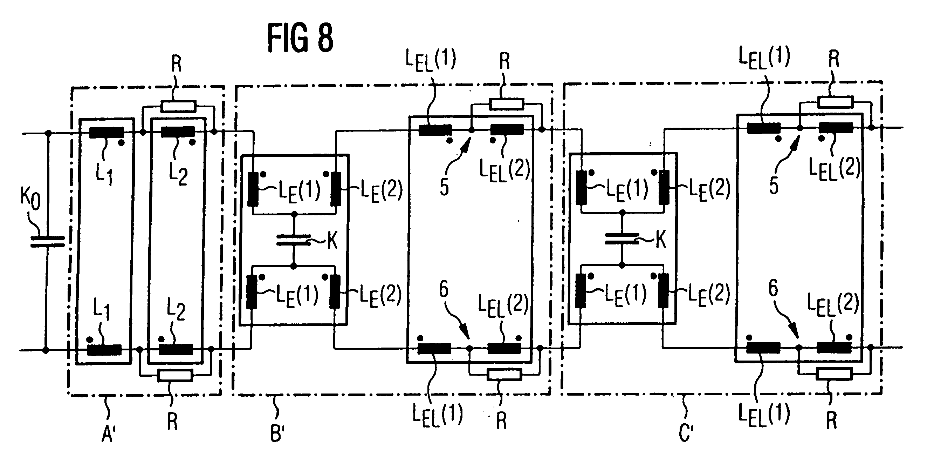

In Figur 8 ist eine Filteranordnung mit einer ersten Filterstufe A', einer zweiten Filterstufe B' und einer dritten Filterstufe C' dargestellt, bei der die Querzweige aus einer ersten Transformation hervorgehen, die Längsinduktivitäten der zweiten Stufe B' und der dritten Stufe C' ebenfalls aus einer ersten Transformation mit vorheriger passiver Transformation und Parallel-Transformation hervorgehen und die Längsinduktivitäten der ersten Stufe aus einer passiven Transformation hervorgehen. Die Werte der Induktivitäten, Widerstände und Kapazitäten lassen sich der Tabelle 2 entnehmen. Die Wicklungssinne der ersten End-Längsinduktivität $L_{EL}(1)$ und der zweiten End-Längsinduktivität $L_{EL}(2)$ der zweiten Filterstufe B' im oberen Längszweig stimmen bezüglich dem fünften Bezugspunkt 5 miteinander überein. Der fünfte Bezugspunkt 5 liegt auf der elektrischen Verbindung zwischen der ersten End-Längsinduktivität $L_{EL}(1)$ und der zweiten End-Längsinduktivität $L_{EL}(2)$. Das Entsprechende gilt für die End-Längsinduktivitäten $L_{EL}(1)$, $L_{EL}(2)$ der dritten Filterstufe C' im oberen Längszweig. Das Entsprechende gilt für die End-Längsinduktivitäten $L_{EL}(1)$, $L_{EL}(2)$ der zweiten Filterstufe B' bzw. der dritten Filterstufe C' im unteren Längszweig bezüglich eines sechsten Bezugspunkts 6.

Tabelle 2

| Bauelement | Stufe | Wert |
|:----------:|:-----:|:----:|
| K0 | 0 | 6.8 nF |
| $L_1$ | A' | 763 $\mu$H |
| $L_2$ | A' | 2598 $\mu$H |
| $2*R$ | A' | 27.5 Ohm |
| $L_E(1)$ | B' | 5.7 $\mu$H |
| $L_E(2)$ | B' | 907 $\mu$H |
| K | B' | 11.7 nF |

(fortgesetzt)

| Bauelement | Stufe | Wert |
|---|---|---|
| $L_{EL}$ (1) | B' | 235 $\mu$H |
| $L_{EL}$ (2) | B' | 4881 $\mu$H |
| 2*R | B' | 51.7 Ohm |
| $L_E$ (1) | C' | 3.6 $\mu$H |
| $L_E$ (2) | C' | 462 $\mu$H |
| K | C' | 10.5 nF |
| $L_{EL}$ (1) | C' | 113 $\mu$H |
| $L_{EL}$ (2) | C' | 2524 $\mu$H |
| 2*R | C' | 26.7 Ohm |

Es liegt im Rahmen der Erfindung, nicht alle Induktivitäten und nicht alle Filterstufen zu transformieren.

Es liegt im Rahmen der Erfindungen, unterschiedliche Querzweige derselben Filteranordnung unterschiedlichen Transformationen zu unterziehen. Dasselbe gilt für die Längsinduktivitäten.

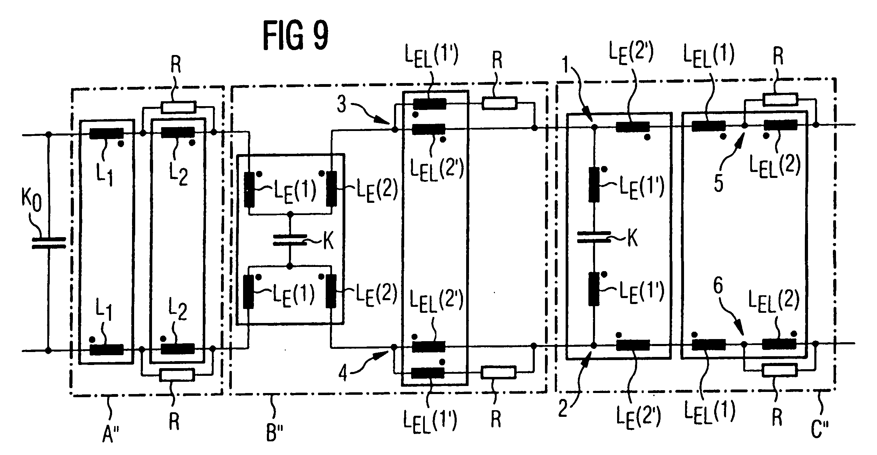

Figur 9 zeigt eine Filteranordnung mit einer ersten Filterstufe A", einer zweiten Filterstufe B" und einer dritten Filterstufe C", bei der der Querzweig der zweiten Filterstufe B" und die Längsinduktivitäten der dritten Filterstufe C" aus einer ersten Transformation hervorgehen, und der Querzweig der dritten Filterstufe C" und die Längsinduktivitäten der zweiten Filterstufe B" aus einer zweiten Transformation hervorgehen. Die Längsinduktivitäten wurden zuvor einer passiven Transformation und einer Parallel-Transformation unterzogen. Die Längsinduktivitäten der ersten Stufe gehen aus einer passiven Transformation hervor. Die Werte der Induktivitäten, Widerstände und Kapazitäten lassen sich der Tabelle 3 entnehmen. Die Wicklungssinne der ersten Endinduktivität $L_E(1')$ und der zweiten Endinduktivität $L_E(2')$ der dritten Filterstufe C" im oberen Längszweig sind bezüglich dem ersten Bezugspunkt 1 zueinander entgegengesetzt. Der erste Bezugspunkt 1 liegt auf der elektrischen Verbindung zwischen der ersten Endinduktivität $L_E(1')$ und der zweiten Endinduktivität $L_E(2')$. Das Entsprechende gilt für die entsprechenden Endinduktivitäten $L_E(1')$, $L_E(2')$ im unteren Längszweig bezüglich einem zweiten Bezugspunkt 2.

Tabelle 3

| Bauelement | Stufe | Wert |
|---|---|---|
| K0 | 0 | 6.8 nF |
| $L_1$ | A" | 763 $\mu$H |
| $L_2$ | A" | 2598 $\mu$H |
| 2*R | A" | 27.5 Ohm |
| $L_E$ (1) | B" | 5.7 $\mu$H |
| $L_E$ (2) | B" | 907 $\mu$H |
| K | B" | 11.7 nF |
| $L_{EL}$ (1') | B" | 235 $\mu$H |
| $L_{EL}$ (2') | B" | 2979 $\mu$H |
| 2*R | B" | 51.7 Ohm |
| $L_E$ (1') | C" | 384 $\mu$H |
| $L_E$ (2') | C" | 3.6 $\mu$H |
| K | C" | 10.5 nF |
| $L_{EL}$ (1) | C" | 113 $\mu$H |
| $L_{EL}$ (2) | C" | 2524 $\mu$H |
| 2*R | C" | 26.7 Ohm |

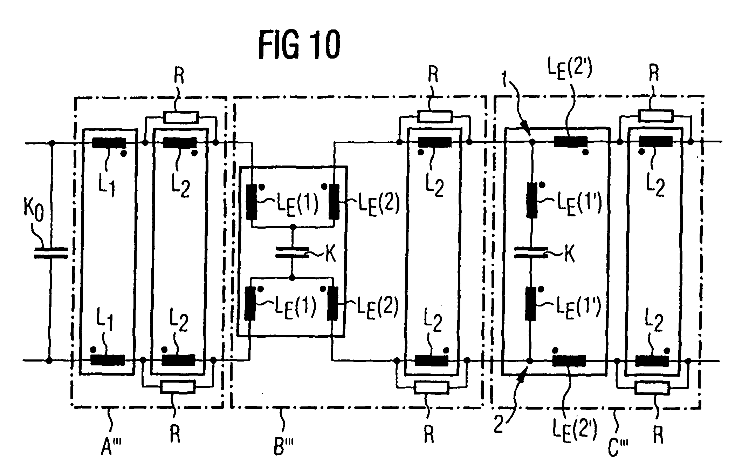

Figur 10 zeigt eine Filteranordnung mit einer ersten Filterstufe A''', einer zweiten Filterstufe B''' und einer dritten Filterstufe C''', bei der der Querzweig der zweiten Filterstufe B''' aus einer ersten Transformation hervorgeht, und der Querzweig der dritten Filterstufe C''' aus einer zweiten Transformation hervorgeht. Die Längsinduktivitäten aller drei Filterstufen A''', B''', C''' gehen aus einer passiven Transformation hervor. Die Werte der Induktivitäten, Widerstände und Kapazitäten lassen sich der Tabelle 4 entnehmen.

Tabelle 4

| Bauelement | Stufe | Wert |
|---|---|---|
| K0 | 0 | 6.8 nF |
| $L_1$ | A''' | 763 $\mu$H |
| $L_2$ | A''' | 2598 $\mu$H |
| 2*R | A''' | 27.5 Ohm |
| $L_E$ (1) | B''' | 5.7 $\mu$H |
| $L_E$ (2) | B''' | 907 $\mu$H |
| K | B''' | 11.7 nF |
| $L_2$ | B''' | 2974 $\mu$H |
| 2*R | B''' | 31.5 Ohm |
| $L_E$ (1') | C''' | 384 $\mu$H |
| $L_E$ (2') | C''' | 3.6 $\mu$H |
| K | C''' | 10.5 nF |
| $L_2$ | C''' | 1569 $\mu$H |
| 2*R | C''' | 16.6 Ohm |

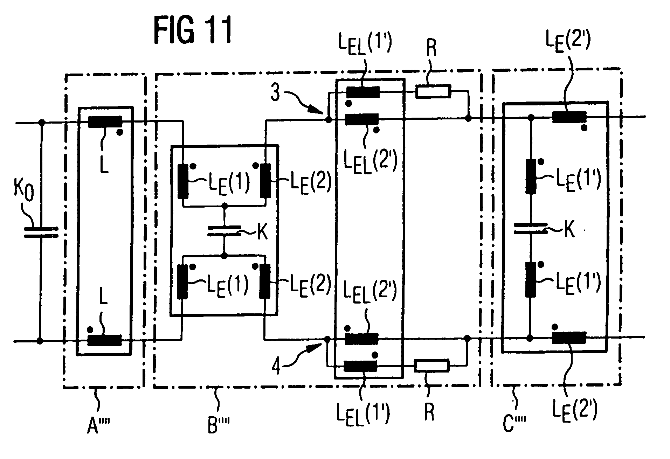

Figur 11 zeigt eine Filteranordnung mit einer ersten FilterStufe A'''', einer zweiten Filterstufe B'''' und einer dritten Filterstufe C'''', bei der der Querzweig der zweiten Filterstufe B'''' aus einer ersten Transformation hervorgeht, und der Querzweig der dritten Filterstufe C'''' aus einer zweiten Transformation hervorgeht. Die Längsinduktivitäten der zweiten Filterstufe B'''' gehen aus einer passiven Transformation, einer Parallel-Transformation und einer anschließenden zweiten Transformation hervor. Die Längsinduktivitäten der ersten Filterstufe A'''' und der dritten Filterstufe C'''' wurden nicht transformiert. Die Werte der Induktivitäten, Widerstände und Kapazitäten lassen sich der Tabelle 5 entnehmen.

Tabelle 5

| Bauelement | Stufe | Wert |
|---|---|---|
| K0 | 0 | 6.8 nF |
| L | 1 | 1016.3 $\mu$H |
| $L_E$ (1) | 2 | 5.7 $\mu$H |
| $L_E$ (2) | 2 | 907 $\mu$H |
| K | 2 | 11.7 nF |
| $L_{EL}$ (1') | 2 | 2974 $\mu$H |
| $L_{EL}$ (2') | 2 | 235.1 $\mu$H |
| 2*R | 2 | 51.7 Ohm |
| $L_E$ (1') | 3 | 535.6 $\mu$H |
| $L_E$ (2') | 3 | 2.74 $\mu$H |
| K | 3 | 10.5 nF |

Bei der Berechnung der Werte der Induktivitäten empfiehlt es sich, vor Transformation der Filterstufe zunächst eine weitere der Filterstufe benachbarte Filterstufe, deren Querzweig unmittelbar an die Filterstufe anschließt, zu transformieren und anschließend die Filterstufe zu transformieren. Auf diese Weise kann die bei der Transformation der weiteren benachbarten Filterstufe eingefügten Kompensationsinduktivität in die freie Längsinduktivität der Filterstufe integriert werden und gleich bei der Transformation der Filterstufe berücksichtigt werden.

**Patentansprüche**

1. Verfahren zum Entwurf einer Filteranordnung mit
   mindestens zwei Längszweigen, die Längsinduktivitäten aufweisen,
   mindestens einer Filterstufe (B), die mindestens einen zwischen die Längszweige geschalteten Querzweig aufweist, und
   mindestens einer benachbarten Filterstufe (A), die sich an den Querzweig unmittelbar anschließt,
   wobei die Anordnung der Induktivitäten mittels Transformation durch folgende Verfahrensschritte bestimmt wird:

   zunächst weist die Filterstufe (B) mindestens eine freie Längsinduktivität ($L_K$') des ersten Längszweigs, eine damit verkoppelte freie Längsinduktivität des zweiten Längszweigs und den Querzweig auf, der aus einer Kapazität (K) besteht, die zwischen zwei miteinander verkoppelten Querinduktivitäten ($L_Q$) geschaltet ist, und zunächst weist die benachbarte Filterstufe (A) mindestens eine freie Längsinduktivität ($L_K$') des ersten Längszweigs und eine damit verkoppelte freie Längsinduktivität des zweiten Längszweigs auf,
   anschließend werden in jeden Längszweig zwischen dem Querzweig und der benachbarten Filterstufe (A) eine vorläufige Längsinduktivität ($L_V$) und ein diese kompensierende und dazu in Reihe geschaltete Kompensationsinduktivität ($L_K$) eingefügt, wobei die vorläufigen Längsinduktivitäten ($L_V$) miteinander verkoppelt werden und die Kompensationsinduktivitäten ($L_K$) miteinander verkoppelt sind,
   anschließend werden die Kompensationsinduktivitäten ($L_K$) in die freien Längsinduktivitäten ($L_1$) der benachbarten Filterstufe (A) integriert,
   anschließend werden die vorläufigen Längsinduktivitäten ($L_V$), die freien Längsinduktivitäten ($L_K$') der Filterstufe (B) und die Querinduktivitäten ($L_Q$) derart durch vier miteinander verkoppelte Endinduktivitäten ($L_E(1)$, $L_E(2)$) ersetzt, dass ein Ersatzschaltbild der vier Endinduktivitäten ($L_E(1)$, $L_E(2)$) mit dem Schaltbild der vorläufigen Längsinduktivitäten ($L_V$), der freien Längsinduktivitäten ($L_K$') der Filterstufe (B) und der Querinduktivitäten ($L_Q$) übereinstimmt.

2. Verfahren zum Entwurf einer Filteranordnung mit mindestens zwei Längszweigen, die Längsinduktivitäten aufweisen,
   mindestens einer Filterstufe (B), die mindestens einen zwischen die Längszweige geschalteten Querzweig aufweist, der aus einer Kapazität (K) besteht, die zwischen zwei miteinander verkoppelten Querinduktivitäten ($L_Q$) geschaltet ist, und
   mindestens einer benachbarten Filterstufe (A), die sich an den Querzweig unmittelbar anschließt,
   wobei die Anordnung der Induktivitäten mittels Transformation durch folgende Verfahrensschritte bestimmt wird:

   zunächst weist die Filterstufe (B''') eine Längsinduktivität (L) des ersten Längszweigs, eine damit verkoppelte Längsinduktivität des zweiten Längszweigs und den Querzweig auf, und die benachbarte Filterstufe (A''') weist zunächst mindestens eine Längsinduktivität (L) des ersten Längszweigs und eine damit verkoppelte Längsinduktivität des zweiten Längszweigs auf,
   anschließend werden die Längsinduktivitäten (L) der Filterstufe (B''') jeweils durch eine erste Längsinduktivität ($L_1$), die zumindest einen Teil der freien Längsinduktivität bildet, und eine dazu in Reihe geschaltete zweite Längsinduktivität ($L_2$), zu der ein Widerstand R parallel geschaltet ist, ersetzt werden, wobei entsprechende Längsinduktivitäten, die zur selben Filterstufe gehören, miteinander verkoppelt sind, und
   anschließend werden die vorläufige Längsinduktivität ($L_V$) und die Kompensationsinduktivität ($L_K$) eingefügt.

3. Verfahren zum Entwurf einer Filteranordnung mit mindestens zwei Längszweigen, die Längsinduktivitäten aufweisen,
   mindestens einer Filterstufe (B), die mindestens einen zwischen die Längszweige geschalteten Querzweig aufweist, der aus einer Kapazität (K) besteht, die zwischen zwei miteinander verkoppelten Querinduktivitäten ($L_Q$) geschaltet ist, und
   mindestens einer benachbarten Filterstufe (A), die sich an den Querzweig unmittelbar anschließt,
   wobei die Anordnung der Induktivitäten mittels Transformation durch folgende Verfahrensschritte bestimmt wird:

zunächst weist die Filterstufe (B) eine Längsinduktivität (L) des ersten Längszweigs, eine damit verkoppelte Längsinduktivität des zweiten Längszweigs und den Querzweig auf, und die benachbarte Filterstufe (A) weist zunächst mindestens eine Längsinduktivität (L) des ersten Längszweigs und eine damit verkoppelte Längsinduktivität des zweiten Längszweigs auf,

anschließend werden die Längsinduktivitäten (L) der Filterstufe (B) und der benachbarten Filterstufe jeweils durch eine erste Längsinduktivität ($L_1$) und eine dazu in Reihe geschaltete zweite Längsinduktivität ($L_2$), zu der ein Widerstand (R) parallel geschaltet wird, ersetzt, wobei entsprechende Längsinduktivitäten, die zur selben Filterstufe gehören, miteinander verkoppelt werden,

anschließend werden die ersten Längsinduktivitäten ($L_1$) und die zweiten Längsinduktivitäten ($L_2$) derselben Filterstufe pro Längszweig durch eine neue erste Längsinduktivität ($L_1'$) und eine neue zweite Längsinduktivität ($L_2'$) derart ersetzt, dass die neue zweite Längsinduktivität ($L_2'$) mit dem Widerstand (R) in Reihe geschaltet ist, diese Reihenschaltung parallel zur neuen ersten Längsinduktivität ($L_1'$) geschaltet ist, bei derselben Filterstufe werden die neuen ersten Längsinduktivitäten ($L_1'$) des ersten Längszweigs und des zweiten Längszweigs miteinander verkoppelt und die neuen zweiten Längsinduktivitäten ($L_2'$) des ersten Längszweigs und des zweiten Längszweigs miteinander verkoppelt,

anschließend werden in jedem Längszweig der Filterstufe (B) eine weitere vorläufige Längsinduktivität ($L_V'$) und eine diese kompensierende weitere Kompensationsinduktivität ($L_K'$), die zumindest ein Teil der freien Längsinduktivität bildet, zwischen der Parallelschaltung der neuen ersten Längsinduktivität ($L_1'$) zur Reihenschaltung und der benachbarten Filterstufe (A) eingefügt,

anschließend werden die weiteren vorläufigen Längsinduktivitäten ($L_V'$), die neuen ersten Längsinduktivitäten ($L_2'$), die ein weiteres Schaltbild bilden, derart durch vier miteinander verkoppelte End-Längsinduktivitäten ($L_E(1')$, $L_E(2')$) ersetzt, dass ein Ersatzschaltbild der vier End-Längsinduktivitäten ($L_E(1')$, $L_E(2')$ mit dem weiteren Schaltbild übereinstimmt, und

anschließend werden die vorläufige Längsinduktivität ($L_v$) und die Kompensationsinduktivität ($L_K$) eingefügt.

4. Verfahren nach einem der Ansprüche 1 bis 3,
bei dem eine erste Elektrode der Kapazität (K) mit einer ersten Endinduktivität ($L_E(1)$), die mit der benachbarten Filterstufe (A) verbunden wird, und mit einer zweiten Endinduktivität ($L_E(2)$) verbunden wird,
bei dem der Wicklungssinn der ersten Endinduktivität ($L_E(1)$) bezüglich der Kapazität (K) mit dem Wicklungssinn der zweiten Endinduktivität ($L_E(2)$) bezüglich der Kapazität (K) übereinstimmt,
bei dem eine zweite Elektrode der Kapazität mit einer dritten Endinduktivität ($L_E(1)$), die mit der benachbarten Filterstufe (A) verbunden ist, und mit einer vierten Endinduktivität ($L_E(2)$) verbunden ist,
bei dem der Wicklungssinn der ersten Endinduktivität ($L_E(1)$) bezüglich der Kapazität (K) entgegengesetzt zum Wicklungssinn der dritten Endinduktivität ($L_E(1)$) bezüglich der Kapazität (K) ist,
bei dem der Wicklungssinn der dritten Endinduktivität ($L_E(1)$) bezüglich der Kapazität (K) mit dem Wicklungssinn der vierten Endinduktivität ($L_E(2)$) bezüglich der Kapazität (K) übereinstimmt.

5. Verfahren nach einem der Ansprüche 1 bis 3,
bei dem eine erste Elektrode der Kapazität (K) mit einer ersten Endinduktivität ($L_E(1')$) verbunden wird, die mit der benachbarten Filterstufe (B") verbunden wird,
bei dem eine zweite Endinduktivität ($L_E(2')$) mit der ersten Endinduktivität ($L_E(1')$) und mit der benachbarten Filterstufe (B") verbunden wird,
bei dem der Wicklungssinn der ersten Endinduktivität ($L_E(1')$) bezüglich einem ersten Bezugspunkt (1) auf der elektrischen Verbindung zwischen der ersten Endinduktivität ($L_E(1')$) und der zweiten Endinduktivität ($L_E(2')$) entgegengesetzt zum Wicklungssinn der zweiten Endinduktivität bezüglich dem ersten Bezugspunkt (1) ist,
bei dem eine zweite Elektrode der Kapazität (K) mit einer dritten Endinduktivität ($L_E(1')$) verbunden wird, die mit der benachbarten Filterstufe (B") verbunden ist,
bei dem eine vierte Endinduktivität ($L_E(2')$) mit der dritten Endinduktivität ($L_E(1')$) und mit der benachbarten Filterstufe (B") verbunden wird,
bei dem der Wicklungssinn der dritten Endinduktivität ($L_E(1')$) bezüglich einem zweiten Bezugspunkt (2) auf der elektrischen Verbindung zwischen der dritten Endinduktivität ($L_E(1')$) und der vierten Endinduktivität ($L_E(2')$) entgegengesetzt zum Wicklungssinn der vierten Endinduktivität ($L_E(2')$) bezüglich dem zweiten Bezugspunkt (2) ist,
bei dem der Wicklungssinn der ersten Endinduktivität ($L_E(1')$) bezüglich der Kapazität (K) entgegengesetzt zum Wicklungssinn der dritten Endinduktivität ($L_E(1')$) bezüglich der Kapazität (K) ist.

6. Verfahren nach einem der Ansprüche 1 bis 3,
bei dem eine erste Elektrode der Kapazität (K) mit einer zweiten Endinduktivität ($L_E(2")$) verbunden ist,
bei dem die zweite Endinduktivität ($L_E(2")$) mit einer ersten Endinduktivität ($L_E(1")$), die mit der benachbarten Filterstufe verbunden ist, verbunden wird,

bei dem der Wicklungssinn der ersten Endinduktivität ($L_E(1")$) bezüglich einem siebten Bezugspunkt (7) auf der elektrischen Verbindung zwischen der ersten Endinduktivität ($L_E(1")$) und der zweiten Endinduktivität ($L_E(2")$) entgegengesetzt zum Wicklungssinn der zweiten Endinduktivität ($L_E(2")$) bezüglich dem siebten Bezugspunkt (7) ist,

bei dem eine zweite Elektrode der Kapazität (K) mit einer vierten Endinduktivität verbunden wird,

bei dem die vierte Endinduktivität mit einer dritten Endinduktivität, die mit der benachbarten Filterstufe verbunden ist, verbunden wird,

bei dem der Wicklungssinn der dritten Endinduktivität bezüglich einem neunten Bezugspunkt auf der elektrischen Verbindung zwischen der dritten Endinduktivität und der vierten Endinduktivität entgegengesetzt zum Wicklungssinn der vierten Endinduktivität bezüglich dem neunten Bezugspunkt ist,

bei dem der Wicklungssinn der ersten Endinduktivität ($L_E(1")$) bezüglich der Kapazität (K) entgegengesetzt zum Wicklungssinn der dritten Endinduktivität bezüglich der Kapazität (K) ist.

7. Verfahren nach einem der Ansprüche 3 bis 6,

bei dem eine erste End-Längsinduktivität ($L_{EL}(1')$) mit dem Widerstand (R) der Filterstufe (B) im ersten Längszweig in Reihe geschaltet ist, und eine zweite End-Längsinduktivität ($L_{EL}(2')$) zu dieser Reihenschaltung parallel geschaltet wird,

bei dem der Wicklungssinn der ersten End-Längsinduktivität ($L_{EL}(1')$) bezüglich einem dritten Bezugspunkt (3) auf der elektrischen Verbindung zwischen der ersten End-Längsinduktivität ($L_{EL}(1')$) und der zweiten End-Längsinduktivität ($L_{EL}(2')$) entgegengesetzt zum Wicklungssinn der zweiten End-Längsinduktivität ($L_{EL}(2')$) bezüglich dem dritten Bezugspunkt (3) ist,

bei dem eine dritte End-Längsinduktivität ($L_{EL}(1')$) mit dem Widerstand (R) der Filterstufe (B) im zweiten Längszweig in Reihe geschaltet wird, und eine vierte End-Längsinduktivität ($L_{EL}(2')$) zu dieser Reihenschaltung parallel geschaltet ist,

bei dem der Wicklungssinn der dritten End-Längsinduktivität ($L_{EL}(1')$) bezüglich einem vierten Bezugspunkt (4) auf der elektrischen Verbindung zwischen der dritten End-Längsinduktivität ($L_{EL}(1')$) und der vierten End-Längsinduktivität ($L_{EL}(2')$) entgegengesetzt zum Wicklungssinn der vierten End-Längsinduktivität ($L_{EL}(2')$) bezüglich dem vierten Bezugspunkt (4) ist,

bei dem der Wicklungssinn der ersten End-Längsinduktivität ($L_{EL}(1')$) bezüglich dem Querzweig entgegengesetzt zum Wicklungssinn der dritten End-Längsinduktivität ($L_E(1')$) bezüglich dem Querzweig ist.

8. Verfahren nach einem der Ansprüche 3 bis 6,

bei dem eine erste End-Längsinduktivität ($L_{EL}(1)$) mit einer zweiten End-Längsinduktivität ($L_{EL}(2)$), zu der der Widerstand (R) der Filterstufe (B') im ersten Längszweig parallel geschaltet ist, in Reihe geschaltet wird,

bei dem der Wicklungssinn der ersten End-Längsinduktivität ($L_{EL}(1)$) bezüglich einem fünften Bezugspunkt (5) auf der elektrischen Verbindung zwischen der ersten End-Längsinduktivität ($L_{EL}(1)$) und der zweiten End-Längsinduktivität ($L_{EL}(2)$) mit dem Wicklungssinn der zweiten End-Längsinduktivität ($L_{EL}(2)$) bezüglich dem fünften Bezugspunkt (5) übereinstimmt,

bei dem eine dritte End-Längsinduktivität ($L_{EL}(1)$) mit einer vierten End-Längsinduktivität ($L_{EL}(2)$), zu der der Widerstand (R) der Filterstufe (B) im zweiten Längszweig parallel geschaltet ist, in Reihe geschaltet wird,

bei dem der Wicklungssinn der dritten End-Längsinduktivität ($L_{EL}(1)$) bezüglich einem sechsten Bezugspunkt (6) auf der elektrischen Verbindung zwischen der dritten End-Längsinduktivität ($L_{EL}(1)$) und der vierten End-Längsinduktivität ($L_{EL}(2)$) mit dem Wicklungssinn der vierten End-Längsinduktivität ($L_{EL}(2)$) bezüglich dem sechsten Bezugspunkt (6) übereinstimmt,

bei dem der Wicklungssinn der ersten End-Längsinduktivität ($L_{EL}(1)$) bezüglich dem Querzweig entgegengesetzt zum Wicklungssinn der dritten End-Längsinduktivität ($L_{EL}(1)$) bezüglich dem Querzweig ist.

9. Verfahren nach einem der Ansprüche 3 bis 6,

bei dem eine zweite End-Längsinduktivität ($L_{EL}(2")$) und ein Widerstand (R) der Filterstufe im ersten Längszweig in Reihe geschaltet, werden,

bei dem eine elektrische Verbindung parallel zur Reihenschaltung aus der zweiten End-Längsinduktivität ($L_{EL}(2")$) und dem Widerstand (R) geschaltet wird,

bei dem eine erste End-Längsinduktivität (LEL(1")) zwischen der benachbarten Filterstufe und der Reihenschaltung aus der zweiten End-Längsinduktivität ($L_{EL}(2")$) und dem Widerstand (R) geschaltet wird,

bei dem der Wicklungssinn der ersten End-Längsinduktivität ($L_{EL}(1")$) bezüglich einem achten Bezugspunkt (8) auf der elektrischen Verbindung zwischen der ersten End-Längsinduktivität ($L_{EL}(1")$) und der zweiten End-Längsinduktivität ($L_{EL}(2")$) mit dem Wicklungssinn der zweiten End-Längsinduktivität ($L_{EL}(2")$) bezüglich dem achten Bezugspunkt (8) übereinstimmt,

bei dem eine vierte End-Längsinduktivität und ein Widerstand der Filterstufe im ersten Längszweig in Reihe geschaltet werden,

bei dem eine elektrische Verbindung parallel zur Reihenschaltung aus der vierten End-Längsinduktivität und dem Widerstand geschaltet wird,

bei dem eine dritte End-Längsinduktivität zwischen der benachbarten Filterstufe und der Reihenschaltung aus der vierten End-Längsinduktivität und dem Widerstand geschaltet wird,

bei dem der Wicklungssinn der dritten End-Längsinduktivität bezüglich einem zehnten Bezugspunkt auf der elektrischen Verbindung zwischen der dritten End-Längsinduktivität und der vierten End-Längsinduktivität mit dem Wicklungssinn der vierten End-Längsinduktivität bezüglich dem zehnten Bezugspunkt übereinstimmt,

bei dem der Wicklungssinn der ersten End-Längsinduktivität ($L_{EL}(1")$) bezüglich dem Querzweig entgegengesetzt zum Wicklungssinn der dritten End-Längsinduktivität bezüglich dem Querzweig ist.

**10.** Verfahren nach einem der Ansprüche 1 bis 9,
bei dem mindestens eine weitere der Filterstufe (B) benachbarte Filterstufe (C) vorgesehen ist,
bei dem die Kompensationsinduktivität ($L_K$) für die Transformation der weiteren benachbarten Filterstufe (C) in die freien Längsinduktivitäten ($L_K$') der Filterstufe (B) integriert wird.

**Claims**

**1.** A method for designing a filter arrangement with
at least two longitudinal branches having longitudinal inductances,
at least one filter stage (B), which has at least one transverse branch connected between the longitudinal branches, and
at least one adjacent filter stage (A), which directly adjoins the transverse branch,
wherein the configuration of the inductances is determined by transformation by the following process steps:

first, the filter stage (B) has at least a free longitudinal inductance ($L_K$') of the first longitudinal branch, a free longitudinal inductance of the second longitudinal branch coupled to it, and the transverse branch, which consists of a capacitance (K) that is connected between two transverse inductances ($L_Q$) coupled to each other, and the adjacent filter stage (A) has at first at least a free longitudinal inductance ($L_K$') of the first longitudinal branch and a free longitudinal inductance of the second longitudinal branch coupled to it,

then, in each longitudinal branch between the transverse branch and the adjacent filter stage (A) a preliminary longitudinal inductance ($L_v$) and a compensating inductance ($L_K$) compensating it and connected in series with it are inserted, whereby the preliminary longitudinal inductances ($L_V$) are coupled to each other and the compensation inductances ($L_K$) are coupled to each other,

then the compensation inductances ($L_K$) are integrated into the free longitudinal inductances ($L_1$) of the adjacent filter stage (A),

then the preliminary longitudinal inductances ($L_V$), the free longitudinal inductances ($L_K$') of the filter stage (B), and the transverse inductances ($L_Q$) are replaced by four end inductances ($L_E(1)$, $L_E(2)$) that are coupled to each other in such a way that an equivalent circuit diagram of the four end inductances ($L_E(1)$, $L_E(2)$) corresponds to the circuit diagram of the preliminary longitudinal inductances ($L_V$), the free longitudinal ($L_K$') of the filter stage (B), and the transverse inductances ($L_Q$).

**2.** A method for designing a filter arrangement with at least two longitudinal branches having longitudinal inductances,
at least one filter stage (B) that has at least one transverse branch which is connected between the longitudinal branches and which consists of a capacitance (K) that is connected between two transverse inductances ($L_Q$) coupled to each other, and
at least one adjacent filter stage (A), which directly adjoins the transverse branch,
whereby the configuration of the inductances is determined by means of transformation by the following process steps:

first, the filter stage (B''') has a longitudinal inductance (L) of the first longitudinal branch, a longitudinal inductance of the second longitudinal branch coupled to it and to the transverse branch, and the adjacent filter stage (A''') first has at least one longitudinal inductance (L) of the first longitudinal branch and a longitudinal inductance of the second longitudinal branch coupled to it,

then the longitudinal inductances (L) of the filter stage (B''') are replaced, respectively, by a first longitudinal inductance ($L_1$), which forms at least a portion of the free longitudinal inductance, and a second longitudinal

inductance ($L_2$) connected in series with it, to which a resistor R is connected in parallel, whereby corresponding longitudinal inductances that belong to the same filter stage are coupled to each other, and
then the preliminary longitudinal inductance ($L_v$) and the compensation inductance ($L_K$) are inserted.

3.  A method for designing a filter arrangement with at least two longitudinal branches having longitudinal inductances, at least one filter stage (B) that has at least one transverse branch which is connected between the longitudinal branches and which consists of a capacitance (K) that is connected between two transverse inductances ($L_Q$) coupled to each other, and
at least one adjacent filter stage (A) that directly adjoins the transverse branch,
whereby the configuration of the inductances is determined by means of transformation by the following process steps:

first, filter stage (B) has a longitudinal inductance (L) of the first longitudinal branch, a longitudinal inductance of the second longitudinal branch coupled to it and to the transverse branch, and the adjacent filter stage (A) first has at least one longitudinal inductance (L) of the first longitudinal branch and a longitudinal inductance of the second longitudinal branch coupled to it,
then the longitudinal inductances (L) of filter stage (B) and the adjacent filter stage are replaced, in each case, by a first longitudinal inductance ($L_1$) and a second longitudinal inductance ($L_2$) connected in series with it, to which a resistor (R) is connected in parallel, whereby corresponding longitudinal inductances that belong to the same filter stage are coupled to each other,
then the first longitudinal inductances ($L_1$) and the second longitudinal inductances ($L_2$) of the same filter stage for each longitudinal branch are replaced by a new first longitudinal inductance ($L_1$') and a new second longitudinal inductance ($L_2$'), in such way that the new second longitudinal inductance ($L_2$') is connected in series with the resistor (R), said series connection is connected in parallel to the new first longitudinal inductance ($L_1$').
In the same filter stage, the new first longitudinal inductance ($L_1$') of the first longitudinal branch and the second longitudinal branch are coupled to each other and the new second longitudinal inductances ($L_2$') of the first longitudinal branch and the second longitudinal branch are coupled to each other,
then, in each longitudinal branch of filter stage (B), an additional preliminary longitudinal inductances ($L_V$') and an additional compensation inductance ($L_K$') compensating the same and forming at least a portion of the free longitudinal inductance, are inserted between the parallel connection of the new first longitudinal inductance ($L_1$') to the series connection and the adjacent filter stage (A),
then, the additional preliminary longitudinal inductances ($L_V$'), the new first longitudinal inductances ($L_2$'), which form an additional circuit diagram, are replaced by four longitudinal end inductances ($L_E$(1'), $L_E$(2')) that are coupled to each other, in such a way that an equivalent circuit diagram of the four longitudinal end inductances ($L_E$(1'), $L_E$(2')) corresponds to the additional circuit diagram, and
then the preliminary longitudinal inductance ($L_V$) and the compensation inductance ($L_K$) are inserted.

4.  A method according to any one of claims 1 through 3,
in which a first electrode of the capacitance (K) is connected to a first end inductance ($L_E$(1)) that is connected to the adjacent filter stage (A) and to a second endinductance ($L_E$(2)),
in which the winding direction of the first end inductance ($L_E$(1)) with respect to the capacitance (K) corresponds to the winding direction of the second end inductance ($L_E$(2)) with respect to the capacitance (K),
in which a second electrode of the capacitance is connected to a third end inductance ($L_E$(1)) that is connected to the adjacent filter stage (A) and to a fourth end inductance ($L_E$(2)),
in which the winding direction of the first end inductance ($L_E$(1)) with respect to the capacitance (K) is opposite to the winding direction of the third end inductance ($L_E$(1)) with respect to the capacitance (K), and
in which the winding direction of the third end inductance ($L_E$(1)) with respect to the capacitance (K) corresponds to the winding direction of the fourth end inductance ($L_E$(2)) with respect to the capacitance (K).

5.  A method according to any one of claims 1 through 3,
in which a first electrode of the capacitance (K) is connected to a first end inductance ($L_E$(1')), which is connected to the adjacent filter stage (B"),
in which a second end inductance ($L_E$(2')) is connected to the first end inductance ($L_E$(1')) and to the adjacent filter stage (B"),
in which the winding direction of the first end inductance ($L_E$(1')) with respect to a first reference point (1) on the electrical connection between the first end inductance ($L_E$(1')) and the second end inductance ($L_E$(2')) is opposite to the winding direction of the second end inductance with respect to the first reference point (1),
in which a second electrode of the capacitance (K) is connected to a third end inductance ($L_E$(1')), which is connected to the adjacent filter stage (B"),

in which a fourth end inductance ($L_E(2')$) is connected to the third end inductance ($L_E(1')$) and to the adjacent filter stage (B"),

in which the winding direction of the third end inductance ($L_E(1')$) with respect to a second reference point (2) on the electrical connection between the third end inductance ($L_E(1')$) and the fourth end inductance ($L_E(2')$) is opposite to the winding direction of the fourth end inductance ($L_E(2')$) with respect to the second reference point (2), and

in which the winding direction of the first end inductance ($L_E(1')$) with respect to the capacitance (K) is opposite to the winding direction of the third end inductance ($L_E(1')$) with respect to the capacitance (K).

6. A method according to any one of claims 1 through 3,

in which a first electrode of the capacitance (K) is connected to a second end inductance ($L_E(2'')$),

in which the second end inductance ($L_E(2'')$) is connected to a first end inductance ($L_E(1'')$), which is connected to the adjacent filter stage,

in which the winding direction of the first end inductance ($L_E(1'')$) with respect to a seventh reference point (7) on the electrical connection between the first end inductance ($L_E(1'')$) and the second end inductance ($L_E(2'')$) is opposite to the winding direction of the second end inductance ($L_E(2'')$) with respect to the seventh reference point (7),

in which a second electrode of the capacitance (K) is connected to a fourth end inductance,

in which the fourth end inductance is connected to a third end inductance that is connected to the adjacent filter stage,

in which the winding direction of the third end inductance with respect to a ninth reference point on the electrical connection between the third end inductance and the fourth end inductance is opposite to the winding direction of the fourth end inductance with respect to the ninth reference point, and

in which the winding direction of the first end inductance ($L_E(1'')$) with respect to the capacitance (K) is opposite to the winding direction of the third end inductance with respect to the capacitance (K).

7. A method according to any one of claims 3 through 6,

in which a first longitudinal end inductance ($L_{EL}(1')$) is connected in series with the resistor (R) of the filter stage (B) in the first longitudinal branch, and a second longitudinal end inductance ($L_{EL}(2')$) is connected in parallel to said series connection,

in which the winding direction of the first longitudinal end inductance ($L_{EL}(1')$) with respect to a third reference point (3) on the electrical connection between the first longitudinal end inductance ($L_{EL}(1')$) and the second longitudinal end inductance ($L_{EL}(2')$ is opposite to the winding direction of the second longitudinal end inductance ($L_{EL}(2')$) with respect to the third reference point (3),

in which a third longitudinal end inductance ($L_{EL}(1')$) is connected in series with the resistor (R) of the filter stage (B) in the second longitudinal branch, and a fourth longitudinal end inductance ($L_{EL}(2')$) is connected in parallel to said series connection,

in which the winding direction of the third longitudinal end inductance ($L_{EL}(1')$) with respect to a fourth reference point (4) on the electrical connection between the third longitudinal end inductance ($L_{EL}(1')$) and the fourth longitudinal end inductance ($L_{EL}(2')$) is opposite to the winding direction of the fourth longitudinal end inductance ($L_{EL}(2')$) with respect to the fourth reference point (4), and

in which the winding direction of the first longitudinal end inductance ($L_{EL}(1')$) with respect to the transverse branch is opposite to the winding direction of the third longitudinal end inductance ($L_E(1')$) with respect to the transverse branch.

8. A method according to any one of claims 3 through 6,

in which a first longitudinal end inductance ($L_{EL}(1)$) is connected in series with a second longitudinal end inductance ($L_{EL}(2)$), to which the resistor (R) of filter stage (B') in the first longitudinal branch is connected in parallel,

in which the winding direction of the first longitudinal end ($L_{EL}(1)$) with respect to a fifth reference point (5) on the electrical connection between the first longitudinal end inductance ($L_{EL}(1)$) and the second longitudinal end inductance ($L_{EL}(2)$) corresponds to the winding direction of the second longitudinal end inductance ($L_{EL}(2)$) with respect to the fifth reference point (5),

in which a third longitudinal end inductance ($L_{EL}(1)$) to a fourth longitudinal end inductance ($L_{EL}(2)$), to which the resistor (R) of filter stage (B) in the second longitudinal branch is connected in parallel, is connected in series,

in which the winding direction of the third longitudinal end inductance ($L_{EL}(1)$) with respect to a sixth reference point (6) on the electrical connection between the third longitudinal end inductance ($L_{EL}(1)$) and the fourth longitudinal end inductance ($L_{EL}(2)$) corresponds to the winding direction of the fourth longitudinal end inductance ($L_{EL}(2)$) with respect to the sixth reference point (6), and

in which the winding direction of the first longitudinal end inductance ($L_{EL}(1)$) with respect to the transverse branch is opposite to the winding direction of the third longitudinal end inductance ($L_E(1)$) with respect to the transverse branch.

9. A method according to any one of claims 3 through 6,
in which a second longitudinal end inductance ($L_{EL}(2'')$) and a resistor (R) of the filter stage in the first longitudinal branch are connected in series,
in which an electrical connection is connected in parallel to the series connection comprised of the second longitudinal end inductance ($L_{EL}(2'')$) and the resistor (R),
in which a first longitudinal end inductance ($L_{EL}(1'')$) is connected between the adjacent filter stage and the series connection comprised of the second longitudinal end inductance ($L_{EL}(2'')$) and the resistor (R),
in which the winding direction of the first longitudinal end inductance ($L_{EL}(1'')$) with respect to an eighth reference point (8) on the electrical connection between the first longitudinal end inductance ($L_{EL}(1'')$) and the second longitudinal end inductance ($L_{EL}(2'')$) corresponds to the winding direction of the second longitudinal end inductance ($L_{EL}(21'')$) with respect to the eighth reference point (8),
in which a fourth longitudinal end inductance and a resistor of the filter stage in the first longitudinal branch are connected in series,
in which an electrical connection is connected in parallel to the series connection comprised of the fourth longitudinal end inductance and the resistor,
in which a third longitudinal end inductance is connected between the adjacent filter stage and the series connection comprised of the fourth longitudinal end inductance and the resistor,
in which the winding direction of the third longitudinal end inductance with respect to a tenth reference point on the electrical connection between the third longitudinal end inductance and the fourth longitudinal end inductance corresponds to the winding direction of the fourth longitudinal end inductance with respect to the tenth reference point,
in which the winding direction of the first longitudinal end inductance ($L_{EL}(1'')$) with respect to the transverse branch is opposite to the winding direction of the third longitudinal end inductance with respect to the transverse branch.

10. A method according to any one of claims 1 through 9,
in which at least one additional filter stage (C) is provided adjacent to filter stage (B),
in which the compensation inductance ($L_K$) for the transformation of the additional adjacent filter stage (C) is integrated into the free longitudinal inductances ($L_K'$) of the filter stage (B).

## Revendications

1. Procédé de conception d'un système de filtre avec
au moins deux branches longitudinales qui présentent des inductances longitudinales,
au moins un étage filtrant (B) qui présente au moins une branche transversale montée entre les branches longitudinales, et
au moins un étage filtrant adjacent (A) qui fait immédiatement suite à la branche transversale,
l'agencement des inductances étant déterminé au moyen d'une transformation par les étapes suivantes du procédé :

tout d'abord l'étage filtrant (B) présente au moins une inductance longitudinale libre ($L_K'$) de la première branche longitudinale, une inductance longitudinale libre, couplée avec celle-ci, de la deuxième branche longitudinale, ainsi que la branche transversale constituée d'une capacité (K) qui est montée entre deux inductances transversales ($L_Q$) couplées l'une à l'autre, et tout d'abord l'étage filtrant adjacent (A) présente au moins une inductance longitudinale libre ($L_K'$) de la première branche longitudinale et une inductance longitudinale libre, couplée avec celle-ci, de la deuxième branche longitudinale,
ensuite on introduit dans chaque branche longitudinale entre la branche transversale et l'étage filtrant adjacent (A) une inductance longitudinale temporaire ($L_v$) et une inductance de compensation compensant celle-ci et montée en série avec, les inductances longitudinales temporaires ($L_v$) étant couplées l'une à l'autre et les inductances de compensation ($L_K$) étant couplées l'une à l'autre,
les inductances de compensation ($L_K$) sont ensuite intégrées dans les inductances longitudinales libres ($L_1$) de l'étage filtrant adjacent (A),
ensuite les inductances longitudinales temporaires ($L_V$), les inductances longitudinales libres ($L_K'$) de l'étage filtrant (B) et les inductances transversales ($L_Q$) sont remplacées par quatre inductances finales ($L_E(1)$, $(LE(2)$) couplées les unes aux autres, de telle façon qu'un schéma de montage de remplacement des quatre inductances finales ($L_E(1)$, $(LE(2)$) concorde avec le schéma de montage des inductances longitudinales temporaires ($L_V$), des inductances longitudinales libres ($L_K'$) de l'étage filtrant (B) et des inductances transversales ($L_Q$).

2. Procédé de conception d'un système de filtre avec
au moins deux branches longitudinales qui présentent des inductances longitudinales,
au moins un étage filtrant (B) qui présente au moins une branche transversale montée entre les branches longitudinales, et une capacité (K) branchée entre deux inductivités transversales ($L_Q$) couplées l'une à l'autre, et
au moins un étage filtrant adjacent (A) qui fait immédiatement suite à la branche transversale,
l'agencement des inductances étant déterminé au moyen d'une transformation par les étapes suivantes du procédé :

tout d'abord l'étage filtrant (B''') présente une inductance longitudinale (L) de la première branche longitudinale, une inductance longitudinale, couplée avec celle-ci, de la deuxième branche longitudinale, ainsi que la branche transversale, et l'étage filtrant adjacent (A''') présente tout d'abord au moins une inductance longitudinale (L) de la première branche longitudinale et une inductance longitudinale, couplée avec celle-ci, de la deuxième branche longitudinale,
ensuite les inductances longitudinales (L) de l'étage filtrant (B''') sont remplacées respectivement par une première inductance longitudinale ($L_1$) qui forme au moins une partie de l'inductance longitudinale libre, et une deuxième inductance longitudinale ($L_2$) montée en série avec celle-ci, par rapport à laquelle une résistance (R) est montée en parallèle, les inductances longitudinales correspondantes, qui appartiennent au même étage filtrant, étant couplées l'une à l'autre, et
ensuite on introduit l'inductance longitudinale temporaire ($L_V$) et l'inductance de compensation ($L_K$).

3. Procédé de conception d'un système de filtre avec
au moins deux branches longitudinales qui présentent des inductances longitudinales,
au moins un étage filtrant (B) qui présente au moins une branche transversale montée entre les branches longitudinales, et une capacité (K) branchée entre deux inductivités transversales ($L_Q$) couplées l'une à l'autre, et
au moins un étage filtrant adjacent (A) qui fait immédiatement suite à la branche transversale,
l'agencement des inductances étant déterminé au moyen d'une transformation par les étapes suivantes du procédé :

tout d'abord l'étage filtrant (B) présente une inductance longitudinale (L) de la première branche longitudinale, une inductance longitudinale, couplée avec celle-ci, de la deuxième branche longitudinale, ainsi que la branche transversale, et l'étage filtrant adjacent (A) présente tout d'abord au moins une inductance longitudinale (L) de la première branche longitudinale et une inductance longitudinale, couplée avec celle-ci, de la deuxième branche longitudinale,
ensuite les inductances longitudinales (L) de l'étage filtrant (B) et de l'étage filtrant adjacent sont remplacées respectivement par une première inductance longitudinale ($L_1$) et une deuxième inductance longitudinale ($L_2$) montée en série avec celle-ci, par rapport à laquelle une résistance (R) est montée en parallèle, les inductances longitudinales correspondantes, qui appartiennent au même étage filtrant, étant couplées l'une à l'autre,
ensuite les premières inductances longitudinales ($L_1$) et les deuxièmes inductances longitudinales ($L_2$) du même étage filtrant sont remplacées, par branche longitudinale, par une nouvelle première inductance longitudinale ($L_1'$) et une nouvelle deuxième inductance longitudinale ($L_2'$), de telle façon que la nouvelle deuxième inductance longitudinale ($L_2'$) est montée en série avec la résistance (R), ce montage en série est monté en parallèle par rapport à la nouvelle première inductance longitudinale ($L_1'$), dans le même étage filtrant les nouvelles premières inductances longitudinales ($L_1'$) de la première branche longitudinale et de la deuxième branche longitudinale sont couplées les unes aux autres et les nouvelles deuxièmes inductances longitudinales ($L_2'$) de la première branche longitudinale et de la deuxième branche longitudinale sont couplées les unes aux autres,
ensuite on introduit dans chaque branche longitudinale de l'étage filtrant (B) une autre inductance longitudinale temporaire ($L_V'$) et une inductance de compensation ($L_K'$) compensant celle-ci, qui forme au moins une partie de l'inductance longitudinale libre, entre le montage de la nouvelle première inductance longitudinale ($L_1'$) en parallèle au montage en série et l'étage filtrant adjacent (A),
ensuite les autres inductances longitudinales temporaires ($L_V'$), les nouvelles premières inductances longitudinales ($L_2'$), qui forment un autre schéma de montage, sont remplacées par quatre inductances longitudinales finales ($L_E(1'$), ($L_E(2')$), couplées les unes aux autres, de telle façon qu'un schéma de montage de remplacement des quatre inductances longitudinales finales ($L_E(1'$), ($L_E(2')$ concordent avec l'autre schéma de montage, et
ensuite on introduit l'inductance longitudinale temporaire ($L_v$) et l'inductance de compensation ($L_K$).

4. Procédé selon l'une des revendications 1 à 3,
selon lequel une première électrode de la capacité (K) est reliée à une première inductance finale ($L_E(1)$), reliée à l'étage filtrant adjacent (A), et à une deuxième inductance finale ($L_E(2)$),
le sens d'enroulement de la première inductance finale ($L_E(1)$) par rapport à la capacité (K) concorde avec le sens d'enroulement de la deuxième inductance finale ($L_E(2)$) par rapport à la capacité (K),

une deuxième électrode de la capacité est reliée à une troisième inductance finale ($L_E$(1)), reliée à l'étage filtrant adjacent (A), et à une quatrième inductance finale ($L_E$(2)),
le sens d'enroulement de la première inductance finale ($L_E$(1)) par rapport à la capacité (K) est opposé au sens d'enroulement de la troisième inductance finale ($L_E$(1)) par rapport à la capacité (K), et
le sens d'enroulement de la troisième inductance finale ($L_E$(1)) par rapport à la capacité (K) concorde avec le sens d'enroulement de la quatrième inductance finale ($L_E$(2)) par rapport à la capacité (K).

5. Procédé selon l'une des revendications 1 à 3,
selon lequel une première électrode de la capacité (K) est reliée à une première inductance finale ($L_E$ (1')) reliée à l'étage filtrant adjacent (B"),
une deuxième inductance finale ($L_E$(2')) est reliée à la première inductance finale ($L_E$(1')) et à l'étage filtrant adjacent (B"),
le sens d'enroulement de la première inductance finale ($L_E$(1')) par rapport à un premier point de référence (1) sur la liaison électrique entre la première inductance finale ($L_E$(1')) et la deuxième inductance finale ($L_E$(2')) est opposé au sens d'enroulement de la deuxième inductance finale par rapport à un premier point de référence (1),
une deuxième électrode de la capacité (K) est reliée à une troisième inductance finale ($L_E$(1')) reliée à l'étage filtrant adjacent (B"),
une quatrième inductance finale ($L_E$(2')) est reliée à la troisième inductance finale ($L_E$(1')) et à l'étage filtrant adjacent (B"),
dans lequel le sens d'enroulement de la troisième inductance finale ($L_E$(1')) par rapport à un deuxième point de référence (2) sur la liaison électrique entre la troisième inductance finale ($L_E$(1')) et la quatrième inductance finale ($L_E$(2')) est opposé au sens d'enroulement de la quatrième inductance finale ($L_E$(2')) par rapport au deuxième point de référence, et
le sens d'enroulement de la première inductance finale ($L_E$(1')) par rapport à la capacité (K) est opposé au sens d'enroulement de la troisième inductance finale ($L_E$(1')) par rapport au à la capacité (K).

6. Procédé selon l'une des revendications 1 à 3,
selon lequel une première électrode de la capacité (K) est reliée à une deuxième inductance finale ($L_E$(2")),
la deuxième inductance finale ($L_E$(2")) est reliée à une première inductance finale ($L_E$(1")), reliée à l'étage filtrant adjacent,
le sens d'enroulement de la première inductance finale ($L_E$(1")) par rapport à un septième point de référence (7) sur la liaison électrique entre la première inductance finale ($L_E$(1")) et la deuxième inductance finale ($L_E$(2")) est opposé au sens d'enroulement de la deuxième inductance finale ($L_E$(2")) par rapport au septième point de référence (7),
une deuxième électrode de la capacité (K) est reliée à une quatrième inductance finale,
la quatrième inductance finale est reliée à une troisième inductance finale, reliée à l'étage filtrant adjacent,
le sens d'enroulement de la troisième inductance finale par rapport à un neuvième point de référence sur le liaison électrique entre la troisième inductance finale et la quatrième inductance finale est opposé au sens d'enroulement de la quatrième inductance finale par rapport au neuvième point de référence, et
le sens d'enroulement de la première inductance finale ($L_E$(1")) par rapport à la capacité (K) est opposé au sens d'enroulement de la troisième inductance finale par rapport à la capacité (K).

7. Procédé selon l'une des revendications 3 à 6,
selon lequel une première inductance longitudinale finale $L_{EL}$ (1')) est montée en série avec la résistance (R) de l'étage filtrant (B) dans la première branche longitudinale et une deuxième inductance longitudinale finale $L_{EL}$ (2')) est montée en parallèle à ce montage en série,
le sens d'enroulement de la première inductance longitudinale finale $L_{EL}$ (1')) par rapport à un troisième point de référence (3) sur la liaison électrique entre la première inductance longitudinale finale $L_{EL}$ (1')) et la deuxième inductance longitudinale finale $L_{EL}$ (2')) est opposé au sens d'enroulement de la deuxième inductance longitudinale finale $L_{EL}$ (2')) par rapport au troisième point de référence,
une troisième inductance longitudinale finale $L_{EL}$ (1')) est montée en série avec la résistance (R) de l'étage filtrant (B) dans la deuxième branche longitudinale et une quatrième inductance longitudinale finale $L_{EL}$ (2')) est montée en parallèle à ce montage en série,
le sens d'enroulement de la troisième inductance longitudinale finale $L_{EL}$ (1')) par rapport à un quatrième point de référence (4) sur la liaison électrique entre la troisième inductance longitudinale finale $L_{EL}$ (1')) et la quatrième inductance longitudinale finale ($L_{EL}$ (2')), est opposé au sens d'enroulement de la quatrième inductivitance longitudinale finale ($L_{EL}$(2') par rapport au quatrième point de référence (4), et
le sens d'enroulement de la première inductance longitudinale finale $L_{EL}$ (1')) par rapport à la branche transversale est opposé au sens d'enroulement de la troisième inductance longitudinale finale ($L_{EL}$ (1')) par rapport à la branche transversale.

8.  Procédé selon l'une des revendications 3 à 6,

selon lequel une première inductance longitudinale finale ($L_{EL}$ (1)) est montée en série avec une deuxième inductance longitudinale finale ($L_{EL}$ (2)), par rapport à laquelle la résistance (R) de l'étage filtrant (B') est montée en parallèle dans la première branche longitudinale,

le sens d'enroulement de la première inductance longitudinale finale ($L_{EL}$ (1)) par rapport à un cinquième point de référence (5) sur la liaison électrique entre la première inductance longitudinale finale ($L_{EL}$ (1)) et la deuxième inductance longitudinale finale ($L_{EL}$ (2)) concorde avec le sens d'enroulement de la deuxième inductance longitudinale finale ($L_{EL}$ (2)) par rapport au cinquième point de référence (5),

une troisième inductance longitudinale finale ($L_{EL}$ (1)) est branchée en série avec une quatrième inductance longitudinale finale ($L_{EL}$ (2)), par rapport à laquelle la résistance (R) de l'étage filtrant (B') est monté en parallèle dans la deuxième branche longitudinale,

le sens d'enroulement de la troisième inductance longitudinale finale ($L_{EL}$ (1)) par rapport à un sixième point de référence (6) sur la liaison électrique entre la troisième inductance longitudinale finale ($L_{EL}$ (1)) et la quatrième inductance longitudinale finale ($L_{EL}$ (2)) concorde avec le sens d'enroulement de la quatrième inductance longitudinale finale ($L_{EL}$ (2)) par rapport au sixième point de référence (6), et

le sens d'enroulement de la première inductance longitudinale finale ($L_{EL}$ (1)) par rapport à la branche transversale est opposé au sens d'enroulement de la troisième inductance longitudinale finale ($L_{EL}$ (1)) par rapport à la branche transversale.

9.  Procédé selon l'une des revendications 3 à 6,

selon lequel une deuxième inductance longitudinale finale ($L_{EL}$ (2")) et une résistance (R) de l'étage filtrant sont montées en série dans la première branche longitudinale,

une liaison électrique est montée en parallèle au montage en série de la deuxième inductance longitudinale finale ($L_{EL}$ (2")) et de la résistance (R),

une première inductance longitudinale finale ($L_{EL}$ (1")) est montée entre l'étage filtrant adjacent et le montage en série de la deuxième inductance longitudinale finale ($L_{EL}$ (2")) et de la résistance (R),

le sens d'enroulement de la première inductance longitudinale finale ($L_{EL}$ (1")) par rapport à un huitième point de référence (8) sur la liaison électrique entre la première inductance longitudinale finale ($L_{EL}$ (1")) et la deuxième inductance longitudinale finale ($L_{EL}$ (2")) concorde avec le sens d'enroulement de la deuxième inductance longitudinale finale ($L_{EL}$ (2")) par rapport au huitième point de référence (8),

une quatrième inductance longitudinale finale et une résistance de l'étage filtrant sont montées en série dans la première branche longitudinale,

une liaison électrique est montée en parallèle au montage en série de la quatrième inductance longitudinale finale et de la résistance,

une troisième inductance longitudinale finale est montée entre l'étage filtrant adjacent et la montage en série de la quatrième inductance longitudinale finale et de la résistance,

le sens d'enroulement de la troisième inductance longitudinale finale par rapport à un dixième point de référence sur la liaison électrique entre la troisième inductance longitudinale finale et la quatrième inductance longitudinale finale concorde avec le sens d'enroulement de la quatrième inductance longitudinale finale par rapport au dixième point de référence, et

le sens d'enroulement de la première inductance longitudinale finale ($L_{EL}$ (1')) par rapport à la branche transversale est opposé au sens d'enroulement de la troisième inductance longitudinale finale par rapport à la branche transversale.

10.  Procédé selon l'une des revendications 1 à 9,

selon lequel au moins un autre étage filtrant adjacent (C) à l'étage filtrant (B) est prévu, et

l'inductance de compensation ($L_K$) est intégrée, pour la transformation de l'autre étage filtrant adjacent (C), dans les inductances longitudinales libres ($L_K$') de l'étage filtrant (B).

FIG 1A

FIG 1B

FIG 1C

FIG 2A

$L_V$    $L_F$

$L_Q$

FIG 2B

$L_K$    $L_V$    $L_F$

$L_Q$

$K$

**FIG 3A**

**FIG 3B**

**FIG 3C**

**FIG 4**

**FIG 5A**

**FIG 5B**

**FIG 6A**

**FIG 6B**

**FIG 6C**

FIG 7

EP 1 151 537 B1

FIG 8

FIG 9

EP 1 151 537 B1

FIG 10

FIG 11

EP 1 151 537 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19851872

**In der Beschreibung aufgeführte Nicht-Patentliteratur**

- **I. ZVEREV.** *Handbook of filter synthesis,* 1967, 59